(19) Europäisches Patentamt
European Patent Office
Office européen des brevets

(11) EP 2 053 672 A1

(12) **EUROPEAN PATENT APPLICATION**
published in accordance with Art. 153(4) EPC

(43) Date of publication:
**29.04.2009 Bulletin 2009/18**

(21) Application number: **07791331.7**

(22) Date of filing: **26.07.2007**

(51) Int Cl.:
***H01L 51/50*** *(2006.01)* ***C09K 11/06*** *(2006.01)*

(86) International application number:
**PCT/JP2007/064631**

(87) International publication number:
**WO 2008/015949 (07.02.2008 Gazette 2008/06)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **04.08.2006 JP 2006213761**

(71) Applicant: **Idemitsu Kosan Co., Ltd.**
**Chiyoda-ku**
**Tokyo 100-8321 (JP)**

(72) Inventors:
- **IWAKUMA, Toshihiro**
  **Sodegaura-shi, Chiba 299-0293 (JP)**
- **ARAKANE, Takashi**
  **Sodegaura-shi, Chiba 299-0293 (JP)**
- **ARAI, Hiromasa**
  **Sodegaura-shi, Chiba 299-0293 (JP)**
- **NAGASHIMA, Hideaki**
  **Sodegaura-shi, Chiba 299-0293 (JP)**

(74) Representative: **Gille Hrabal Struck Neidlein Prop Roos**
**Brucknerstraße 20**
**40593 Düsseldorf (DE)**

(54) **ORGANIC ELECTROLUMINESCENCE DEVICE**

(57) An organic electroluminescent device, including: a cathode; an anode; and organic layers including at least an emitting layer and an electron-transporting layer between the cathode and the anode, the electron-transporting material with the slowest electron mobility constituting the electron-transporting layer having an electron mobility of $2.0\times10^{-5}$ $cm^2/Vs$ or more in an electric field intensity of 0.4 to 0.5 MV/cm, the electron mobility/hole mobility ($\Delta EM$) of a host material constituting the emitting layer, and the electron mobility/hole mobility ($\Delta ET$) of the electron-transporting material with the slowest electron mobility constituting the electron-transporting layer satisfying the following relationship: $\Delta ET > 1$, $0.3 \leq \Delta EM \leq 10$, and $\Delta ET > \Delta EM$.

FIG. 1

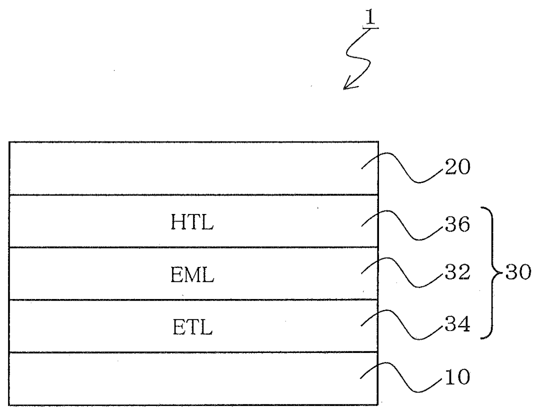


EP 2 053 672 A1

## Description

TECHNICAL FIELD

The invention relates to an organic electroluminescence (EL) device improved in emission performance and life.

BACKGROUND ART

In organic electroluminescence (EL) devices, multilayer organic EL devices with three or more layers in which hole-transporting, emitting and electron-transporting functions are separated have come to constitute the mainstream of the organic EL devices since they can realize efficient emission. In this type of organic EL device, a material obtained by dispersing a fluorescent dye (guest) having a high quantum yield such as a laser dye in a solid medium (host) is used as the material for an emitting layer. By this configuration, the fluorescent quantum yield of an emitting layer can be improved, whereby not only the quantum efficiency of an organic EL device is drastically improved but also the emission wavelength thereof can be controlled freely by appropriately selecting the fluorescent dye.

Another advantage of the multilayer device is the "carrier-confining effect". As examples of the characteristics of materials exhibiting the carrier-confining effect, examples shown in FIGs. 3 and 4 can be given.

FIG. 3 shows an example in which an electron-transporting emitting layer is used. This device is configured such that holes and electrons can be accumulated easily in the interface between the hole-transporting layer and the emitting layer due to the electron-transporting properties of the host material forming the emitting layer. That is, by providing a barrier by making the ionization potential of the host material forming the emitting layer larger than that of the host-transporting material forming the hole-transporting layer, holes are allowed to be accumulated easily in the interface between the hole-transporting layer and the emitting layer. In addition, by enhancing electron-blocking properties by making the absolute value of the energy level of the electron affinity of the host-transporting material forming the hole-transporting layer larger than that of the host material forming the emitting layer, electrons are allowed to be accumulated easily in the interface between the emitting layer and the hole-transporting layer and the coupling rate of electrons and holes is increased, whereby luminous efficiency can be enhanced. Strictly speaking, this ionization potential and the electron affinity have different meanings. However, the ionization potential and the electron affinity are close to the highest-occupied molecular orbital and the lowest-unoccupied molecular orbital, respectively, and they are almost the same in magnitude. The configuration shown in FIG. 3 is disclosed in Patent Document 1. Specifically, in Patent Document 1, a technology is disclosed in which a phosphorescent dopant is added to an electron-transporting host to increase the carrier-recombining rate at the interface with the hole-transporting layer, whereby the device is allowed to emit light with a high efficiency.

FIG. 4 shows an example in which a host-transporting emitting layer is used. The example shown in FIG. 4 is configured such that holes and electrons tend to accumulate in the interface between the emitting layer and an electron-transporting layer, since the host material constituting the emitting layer has hole-transporting properties. That is, by providing a barrier by making the ionization potential of an electron-transporting material constituting the electron-transporting layer larger than that of the host material constituting the emitting layer, holes are allowed to be accumulated in the interface between the emitting layer and the electron-transporting layer easily. In addition, by enhancing electron-blocking properties by making the absolute value of the energy level of the electron affinity of the electron-transporting material constituting the electron-transporting layer larger than that of the host material constituting the emitting layer, electrons are allowed to be accumulated easily in the interface between the emitting layer and the electron-transporting layer, and the coupling rate of electrons and holes is allowed to increase, whereby luminous efficiency is increased. However, if these electron-blocking properties and hole-blocking properties are too large, problems occur that the driving voltage of a device is increased, holes and electrons (carriers) are ill-balanced, or the like. Therefore, suitable blocking properties are required, and an energy barrier of about 0.2 eV is general.

However, when an electron-transporting emitting layer as shown in FIG. 3 is used, only the relationship between the emitting layer and the hole-transporting layer has been discussed. On the other hand, when a hole-transporting emitting layer is used as shown in FIG. 4, only the relationship between the emitting layer and the electron-transporting layer has been discussed. In the former, it is totally unclear what kind of effects are exerted on the device performance when the electron-transporting properties of the electron-transporting layer are multiplied by the properties of the emitting layer, and in the latter, it is also totally unclear what kind of effects are exerted on the device performance when the hole-transporting properties of the hole-transporting layer are multiplied by the properties of the emitting layer.

Using an electron-transporting material having a high electron-transporting capability in the electron-transporting layer is an effective means to enhance luminous efficiency. The reason therefor is as follows. The number of electrons present per unit time in the emitting layer increases, resulting in an increase in the number of excitons which can be recombined with holes. However, it is impossible to obtain a durable device by simply enhancing electron-transporting properties. An illustrative view showing this relationship is given in FIGs. 5 and 6.

FIG. 5 is a view in which an electron-transporting layer having electron-transporting properties is added to the view shown in FIG. 3. As in the case of FIG. 3, the device shown in FIG. 5 is configured such that holes and electrons are allowed to be accumulated easily in the interface between the hole-transporting layer and the emitting layer. It is thought that, if the electron-transporting capability of the emitting layer is high, recombination occurs in a further localized interface, in other words, in a region of the emitting layer which is in close proximity to the hole-transporting layer. If an electron-transporting layer having a high degree of electron transporting capability is used, effects will be enhanced that recombination occurs in a region of the emitting layer which is in closer proximity to the hole-transporting layer. However, in this case, if the electron-transporting capability of the emitting layer is too high, electrons enter a region of the emitting layer which is in close proximity to the hole-transporting layer, or in some cases, not only in this region, electrons also enter the hole-transporting layer, and recombine with holes in the hole-transporting layer. As a result, a phenomenon tends to occur in which the hole-transporting layer emits light. In particular, when an arylamine-based hole-transporting layer is used, deterioration of a hole-transporting material is accelerated by the injection of electrons. As a result, luminous efficiency tends to deteriorate with the passage of time, causing device durability to lower. If recombination intensively occurs in a local region of the emitting layer which is in close proximity to the hole-transporting layer, even if deterioration of the layer interface occurs very locally, such deterioration largely affects the device, and singlet excitons and triplet excitons generated by the recombination are trapped, luminous efficiency is decreased with the passage of time, resulting in the formation of a device having poor durability.

FIG. 6 is a view in which a hole-transporting layer having hole-transporting properties is added to the view shown in FIG. 4. In this case, the emitting layer has hole-transporting properties, and if the hole-transporting capability of the emitting layer is high, recombination occurs in a local interface between the emitting layer and the electron-transporting layer. Since recombination occurs in a local region in close proximity to the electron-transporting layer, if the singlet energy gap or the triplet energy gap of the electron-transporting layer is smaller than the energy of singlet excitons or triplet excitons generated by the recombination, energy is leaked to the electron-transporting layer, whereby luminous efficiency is lowered. As a result, material selection of the electron-transporting material is restricted. In the case of a phosphorescent organic EL device, in order to prevent the leakage of the triplet exciton energy, an electron-transporting material having a large triplet energy gap is required. In addition, if the hole-transporting capability of the emitting layer is too large as compared with the electron-transporting capability of the electron-transporting layer, recombination occurs in a region of the emitting layer in closer proximity to the electron-transporting layer. In some cases, holes enter the electron-transporting layer, and recombine with electrons in the electron-transporting layer, whereby a phenomenon occurs in which the electron-transporting layer emits light. In this case, if an electron-transporting layer which is unstable to holes is used, deterioration of an electron-transporting material is accelerated by the injection of holes. As a result, luminous efficiency tends to deteriorate with the passage of time, causing the device durability to be lowered. In addition, if recombination occurs intensively in a local region of the emitting layer which is in close proximity to the electron-transporting layer, even if deterioration of the layer interface occurs very locally, such deterioration tends to affect the device performance significantly. Therefore, in order to prevent holes from being injected to the electron-transporting layer, it is required to use an electron-transporting layer which effectively blocks holes and keeps holes inside of the emitting layer. As a result, materials realizing a high-efficiency and long-life organic EL device are hard to find.

In a phosphorescent device, if the host material constituting the emitting layer has hole-transporting properties, a highly efficient device cannot be realized unless the ionization potential of an electron-transporting material is made larger than the ionization potential of a host material.

In a blue phosphorescent device of which the value of energy associated with emission is high, if the triplet energy gap of a layer adjacent to the emitting layer is small, confinement of triplet exciton energy in the emitting layer is not sufficient. As a result, the energy is leaked to adjacent layers, resulting in a significant lowering of luminous efficiency.

In order to improve both luminous efficiency and driving stability of an organic EL device, provision of a hole-blocking layer between the emitting layer and the cathode is proposed. The hole-blocking layer restricts the move of holes from the emitting layer. As the hole-blocking material, a phenanthroline derivative (see Patent Document 2) and a triazole derivative (see Patent Document 3) are reported to be effective. In a phosphorescent device, an anthracene derivative (see Patent Document 4), a phenanthroline derivative (see Non-patent Document 1) or an aluminum chelate such as BAlq (see Non-patent Document 2) is used as a hole-blocking layer. As mentioned above, due to the provision of a hole-blocking layer, holes can be accumulated in an emitting layer and recombining rate with electrons can be improved, whereby high luminous efficiency can be attained.

However, if these hole-blocking materials are used, a phosphorescent device which has a sufficient luminous efficiency and a long life cannot necessarily be obtained. It is believed that, if a phenanthroline derivative is used, although the efficiency of a phosphorescent device is improved, the driving stability thereof is low. On the other hand, if BAlq is used, while driving stability is improved, efficiency tends to lower. Therefore, improvement of both driving stability and efficiency is desired. As for a phosphorescent device, it is disclosed that luminous efficiency is improved when the energy gap of the electron-transporting layer is larger than that of the emitting layer (Patent Document 5). When an anthracene derivative is used in an electron-transporting layer (hole-transporting layer), due to a smaller energy gap than that of

the emitting layer, efficiency is low in green and blue phosphorescent devices, and the device life is short. The reason therefor is as follows. Since the energy gap of the anthracene skeleton is significantly low as compared with that of an emitting material (that is, the band gap is narrow), the exciton energy of the emitting layer is leaked to a layer in which an anthracene derivative is used. As a result, emission is observed in a layer in which an anthracene derivative is used, or the energy is lost from triplet excitons generated in a layer in which an anthracene derivative is used due to the radiationless deactivation.

These known documents only refer to whether the emitting material has electron-transporting properties or hole-transporting properties. No reference is made to the relationship with the hole or electron mobility of a host material constituting the emitting layer, let alone the relationship with the hole or electron mobility of a main material constituting a layer on the cathode side or the anode side of the emitting layer.

In Patent Document 4, a hole-transporting host material is used in the Examples. No specific statement is made on the carrier mobility of the electron-transporting material and the hole-transporting host material.

Patent Document 6 discloses a technology of providing, between the electron injecting transporting layer and the emitting layer, a non-emitting layer which has a higher degree of hole transporting properties than the electron injecting transporting layer and has electron transporting properties. However, the presence of any preferable relationship between the emitting layer, and the hole-transporting properties and electron-transporting properties of the electron injecting transporting layer or the electron-transporting non-emitting layer has not been elucidated at all.

Patent Document 7 shows a preferable relationship between the hole mobility between a plurality of layers constituting the hole-transporting layer, the hole mobility and the electron mobility between a plurality of layers constituting the emitting layer, and the electron mobility between a plurality of layers constituting the electron-transporting layer. However, no statement is made concerning a preferable relationship between the mobility of the emitting layer and the mobility of the electron-transporting layer.

Patent Document 1: Japanese Patent No. 3759925
Patent Document 2: JP-A-H10-79297
Patent Document 3: JP-A-H10-233284
Patent Document 4: JP-A-2006-049570
Patent Document 5: U.S. Patent No. 6097147
Patent Document 6: WO 2004/077886
Patent Document 7: JP-A-2002-313583
Non-patent Document 1: Appl. Phys. Lett. 75, 4 (1999)
Non-patent Document 2: Proc. SPIE, Vol. 4105, P175-182 (2000)

The object of the invention is to provide a highly efficient and long-lived organic EL device which exhibits a higher degree of electron-transporting properties than conventional electron-transporting materials even when an electron-transporting material having a narrow triplet energy gap (2.1 eV or less) is used.

DISCLOSURE OF THE INVENTION

The inventors made intensive studies on the relationship between the hole mobility and the electron mobility of the emitting layer and the hole mobility and the electron mobility of the electron-transporting layer, and have found that a device which is driven at a low voltage, and has a high luminous efficiency and a long life can be obtained when they satisfy a specific relationship, even when an electron-transporting material having a narrow triplet energy gap (for example, 2.1 eV or less) is used. The invention has been made based on this finding.

According to the invention, the following organic EL device can be provided.

1. An organic electroluminescent device, comprising:

a cathode;
an anode; and
organic layers comprising at least an emitting layer and an electron-transporting layer between the cathode and the anode,
the electron-transporting material with the slowest electron mobility constituting the electron-transporting layer having an electron mobility of $2.0\times10^{-5}$ $cm^2/Vs$ or more in an electric field intensity of 0.4 to 0.5 MV/cm,
the electron mobility/hole mobility ($\Delta EM$) of a host material constituting the emitting layer, and the electron mobility/hole mobility ($\Delta ET$) of the electron-transporting material with the slowest electron mobility constituting the electron-transporting layer satisfying the following relationship:

$$\Delta ET > 1$$

$$0.3 \leq \Delta EM \leq 10$$

$$\Delta ET > \Delta EM.$$

2. The organic electroluminescent device according to 1, wherein $\Delta ET \geq 3$.
3. The organic electroluminescent device according to 1 or 2, wherein the ionization potential of the electron-transporting material is equal to or less than the ionization potential of the host material.
4. The organic electroluminescent device according to any one of 1 to 3, wherein the singlet energy gap or the triplet energy gap of the electron-transporting material is less than the singlet energy gap or the triplet energy gap of the host material.
5. The organic electroluminescent device according to any one of 1 to 4, wherein the emitting layer has at least one dopant material and at least one host material.
6. The organic electroluminescent device according to 5, wherein the dopant material is a phosphorescent material.
7. The organic electroluminescent device according to 6, wherein the phosphorescent material is an orthomethalated metal complex.
8. The organic electroluminescent device according to any one of 5 to 7, wherein the dopant material has an emission wavelength peak of 500 nm or less.
9. An organic electroluminescent device according to any one of 1 to 8, wherein at least one electron-transporting material constituting the electron-transporting layer has a triplet energy gap of 2.1 eV or less.
10. The organic electroluminescent device according to any one of 1 to 9, wherein the electron-transporting layer comprises a compound having an anthracene skeleton.
11. The organic electroluminescent device according to 10, wherein the compound having an anthracene skeleton is shown by the following formula:

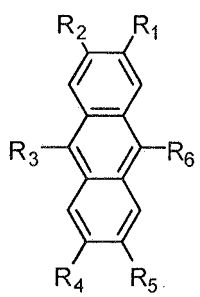

wherein $R_1$ to $R_6$ are independently a hydrogen atom, a substituted or unsubstituted alkyl group having 1 to 40 carbon atoms, a substituted or unsubstituted perfluoroalkyl group having 1 to 40 carbon atoms, a substituted or unsubstituted alkoxy group having 1 to 40 carbon atoms, a substituted or unsubstituted aralkyl group having 1 to 40 carbon atoms, a substituted or unsubstituted arylalkoxy group having 1 to 40 carbon atoms, a substituted or unsubstituted aryl group having 6 to 80 carbon atoms, a substituted or unsubstituted heterocyclic group having 3 to 80 carbon atoms, a substituted or unsubstituted alkylsilyl group having 1 to 40 carbon atoms, a substituted or unsubstituted arylsilyl group having 6 to 80 carbon atoms, or a cyano group, and adjacent substituents may be bonded to each other to form a ring.
12. The organic electroluminescent device according to any one of 1 to 11, wherein the electron-transporting layer comprises a condensed aromatic ring derivative containing an electron-deficienct nitrogen-containing five-membered ring or a condensed aromatic ring derivative containing a nitrogen-containing six-membered ring.
13. The organic electroluminescent device according to 12, wherein the nitrogen-containing five-membered ring is an imidazole ring, a triazole ring, a tetrazole ring, an oxadiazole ring, a thiadiazole ring, an oxatriazole ring, or a thiatriazole ring.
14. The organic electroluminescent device according to 12, wherein the nitrogen-containing six-membered ring is a quinoxaline ring, a quinoline ring, a quinazoline ring, a pyridine ring, a pyrazine ring, or a pyrimidine ring.

15. The organic electroluminescent device according to any one of 1 to 14, wherein a reductive dopant is added in the interfacial region of the organic layers and the cathode.
16. The organic electroluminescent device according to any one of 1 to 15, wherein the emitting layer has a film thickness of 20 nm or more.
17. The organic electroluminescent device according to any one of 1 to 16, further comprising a donor layer or an accepter layer between at least one electrode of the cathode and the anode, and the organic layers.

The invention can provide a highly efficient and long-lived phosphorescent device of which the energy loss from the emitting layer to the electron-transporting layer is small.

BRIEF DESCRIPTION OF THE DRAWINGS

FIG. 1 is a view showing a configuration of an organic EL device according to one embodiment of the invention;
FIG. 2A is an energy diagram of the organic EL device according to one embodiment of the invention;
FIG. 2B is an energy diagram of the organic EL device according to another embodiment of the invention;
FIG. 3 is an energy diagram of a conventional EL device;
FIG. 4 is an energy diagram of another conventional EL device;
FIG. 5 is an energy diagram of another conventional EL device; and
FIG. 6 is an energy diagram of another conventional EL device.

BEST MODE FOR CARRYING OUT THE INVENTION

The organic EL device of the invention comprises a cathode, an anode and organic layers comprising at least an emitting layer and an electron-transporting layer between the cathode and the anode.
One embodiment of such an organic EL device is shown in FIG. 1. As shown in FIG. 1, an organic EL device 1 comprises a cathode 10, an anode 20 and organic layers 30 between them. The organic layers 30 comprise an electron-transporting layer 34, an emitting layer 32 and a hole-transporting layer 36 being stacked from the cathode side. As mentioned later, the configuration of the organic EL device of the invention is not limited to the one shown in FIG. 1. The organic layers may contain other appropriate layers insofar as they contain at least the electron-transporting layer and the emitting layer.
In the invention, the electron mobility of an electron-transporting material constituting the electron-transporting layer 34 having the slowest electron mobility is $2.0 \times 10^{-5}$ $cm^2/Vs$ or more in an electric field intensity of 0.4 to 0.5 MV/cm. The electron mobility is preferably $2.5 \times 10^{-5}$ $cm^2/Vs$ or more in an electric field intensity of 0.5 MV/cm. Due to this electron mobility, emission from the electron-transporting material can be suppressed, whereby highly efficient emission with a long life can be attained without suffering energy loss. The electron mobility is preferably $1.0 \times 10^{-2}$ $cm^2/Vs$ or less.
Furthermore, the electron mobility of a host material constituting the emitting layer 32/the hole mobility of a host material constituting the emitting layer 32 (electron mobility ÷ hole mobility) (ΔEM) and the electron mobility of the electron-transporting material with the slowest electron mobility constituting the electron-transporting layer 34/the hole mobility of the electron-transporting material with the slowest electron mobility constituting the electron-transporting layer 34 (electron mobility ÷ hole mobility) (ΔET) satisfies the following relationship:

$$\Delta ET > 1$$

$$0.3 \leq \Delta EM \leq 10$$

$$\Delta ET > \Delta EM.$$

Since the ΔET is larger than 1, electrons can reach the emitting layer quickly and emission from the electron-transporting material can be prevented. As a result, highly efficient emission having a long life can be obtained without suffering energy loss. It is preferred that ΔET be 3 or more.

When the ΔEM value is not less than 0.3 and not more than 10, the recombining zone of electrons and holes can be positioned in a well-balanced manner in a region of the emitting layer in close proximity to the hole-transporting layer, without bringing the recombining zone in excessively close proximity to the hole-transporting layer. As a result, device life can be prolonged. If the ΔEM is 0.3 or less, since the hole-transporting properties are too strong, electron-transporting layer having a small singlet energy gap or a small triplet energy gap, or an electron-transporting layer having a small ionization potential (i.e. having a smaller degree of hole-blocking properties) emits light. It is preferred that the ΔEM be not less than 0.5 and not more than 5.
In view of the above, as the host material, a material which does not have excessively high hole-transporting properties but has a high degree of electron-transporting properties, or a material which has a moderate degree of the hole-transporting properties and the electron-transporting properties is preferable.
Since ΔET is larger than ΔEM, it is possible to allow electrons to quickly reach the emitting layer, and allow electrons to be confined in a region of the emitting layer near the anode. As a result, the possibility that excitons are present in the interface between the emitting layer and the electron-transporting layer can be significantly decreased. As a result, emission from the electron-transporting material can be prevented. It is preferred that ΔET be 10 times larger than ΔEM.

As mentioned above, by adjusting the hole mobility and the electron mobility of the emitting layer 32 and the electron-transporting layer 34, the organic EL device has a high efficiency and a long life. In particular, an emitting device having a high efficiency and a long life can be obtained even though a dopant material is not added to an electron-transporting host material.

As shown in FIGs. 2A and 2B, even when a hole-transporting host material is used as the emitting layer 32, as long as an electron-transporting material constituting the electron-transporting layer 34 satisfies the above-mentioned conditions, even a device using an electron-transporting material which does not have electron-blocking properties can emit light with a high degree of efficiency. In addition, hole-blocking properties or energy-blocking properties, which have conventionally been required particularly in a phosphorescent device, are not required for the electron-transporting material.

Further, since excitons are formed mainly in a region near the anode of the emitting layer, the ionization potential of the electron-transporting material with the slowest electron mobility constituting the electron-transporting layer 34 is not required to be larger than the ionization potential of the host material constituting the emitting layer 32. It is preferred that the ionization potential of the electron-transporting material with the slowest electron mobility be equal to or less than the ionization potential of the host material.

The emitting layer normally contains a dopant material and a host material. As for the dopant material and the host material, one dopant material and one host material may be used or two or more dopant materials and two or more host materials may be used. Examples of the dopant material include fluorescent materials and phosphorescent materials.

As compared with a phosphorescent device, in the case of a fluorescent device, a larger or smaller energy gap of the electron-transporting layer than the host material exerts no effect on the device performance, since excitons have a short life and relax very quickly. However, in a phosphorescent device, excitons have a longer life than the excitons generated in a fluorescent device, and move around within the emitting layer. Therefore, it is believed that the carrier mobility of the material has a larger effect on the device as compared with a fluorescent device. According to the relationship of the carrier mobility of the invention, even if the singlet energy gap or the triplet energy gap of the electron-transporting material with the slowest electron mobility constituting the electron-transporting layer is smaller than the singlet energy gap or the triplet energy gap of the host material of the emitting layer, performance of a phosphorescent EL device can be sufficiently exhibited.

As mentioned above, if a phosphorescent material is used as a dopant material, the advantageous effects of the invention will be significantly exhibited. If a phosphorescent material is used, a material having triplet energy larger than that of a phosphorescent material is preferable as the host material since it confines excited triplet energy of the phosphorescent material. Examples thereof include a carbazole derivative and a polyphenylene derivative stated later.
As preferred examples of an electron-transporting material when using a phosphorescent material, an anthracene skeleton derivative, a condensed aromatic ring derivative containing an electron-deficient nitrogen-containing five-membered ring or an electron-deficient nitrogen containing six-membered ring, which is described later, can be given.

Examples of the nitrogen-containing five-membered ring include an imidazole ring, a triazole ring, a tetrazole ring, an oxadiazole ring, a thiadiazole ring, an oxadiazole ring or a thiatriazole ring. Examples of the nitrogen-containing six-membered ring include a quinoxaline ring, a quinoline ring, a quinazoline ring, a pyridine ring, a pyrazine ring and a pyrimidine ring.

The emission wavelength peak of the dopant material is preferably 500 nm or less. If it is 500 nm or less, blue emission becomes possible, and a white emitting device can be obtained by combining with red emission and green emission.

In the organic EL device shown in FIG. 1, between the anode 20 and the hole-transporting layer 36 and/or between the cathode 10 and the electron-transporting layer 34, a donor layer or an acceptor layer may be present. Due to the presence of the donor layer or the acceptor layer, the amount of holes and electrons can be increased within the

device, whereby the driving voltage of the device can be decreased.
It is preferred that the acceptor layer be present between the anode 20 and the hole-transporting layer 36.
Furthermore, it is preferred that the donor layer be present between the cathode 10 and the electron-transporting layer 34. They may be used in combination in the same device in such a manner that the acceptor layer is present between the anode and the hole-transporting layer and the donor layer is present between the cathode and the electron-transporting layer.

Each member constituting the organic EL device of the invention will be described below.

1. Anode

As the anode, it is preferable to use metals, alloys, electric conductive compounds and mixtures thereof with a large work function (for example, 4.0 eV or more). Specifically, indium tin oxide (ITO), indium-zinc oxide (IZO), indium copper, tin, zinc oxide, gold, platinum, palladium, etc. can be used singly or in a combination of two or more.

The anode can be formed by forming these electrode materials into a thin film by vapor deposition, sputtering or the like. Although there are no specific restrictions on the thickness of the anode, it is preferably 10 to 1000 nm, more preferably 10 to 200 nm. When light emitting from the organic layer is outcoupled through the anode, the anode is substantially transparent, i.e. has a light transmittance of 50% or more.

2. Cathode

As the cathode, it is preferable to use metals, alloys, electric conductive compounds and mixtures thereof with a small work function (for example, less than 4.0 eV) . Specifically, magnesium, aluminum, indium, lithium, sodium, cesium, silver, etc. can be used singly or in a combination of two or more. Although there are no specific restrictions on the thickness of the cathode, the thickness is preferably 10 to 1000 nm, more preferably 10 to 200 nm.

3. Organic layers

The organic layers include an emitting layer which can give EL emission upon recombination of electrons and holes. The organic layers may be constructed by stacking the following layers.

(i) Emitting layer/electron-transporting layer
(ii) Hole-transporting layer/emitting
layer/electron-transporting layer
(iii) Hole-transporting layer/emitting layer/electron-transporting layer/electron-injecting layer
(iv) Hole-injecting layer/hole-transporting layer/emitting layer/electron-transporting layer/electron-injecting layer
(v) Hole-injecting layer/hole-transporting layer/emitting layer/electron-transporting layer/electron-transporting layer/electron-injecting layer

Of these, normally, the structures (ii) to (v) are preferably used since a device which exhibits a higher degree of luminance and has improved durability can be obtained.

In order to improve carrier balance and carrier-inj ection properties, the organic layers may contain an inorganic semiconductor layer, an inorganic oxide thin film layer, a donor-type organic thin film layer, an acceptor-type organic thin film layer or the like may be provided according to need. As for the organic thin film layer as mentioned above, a plurality of the layers may be stacked or the layers may be provided such that they are separated from each other. It is also possible to use these layers in combination.

[Emitting layer]

As examples of the host material or the dopant material which may be used for the emitting layer, an arylamine compound and/or styrylamine compound, anthracene, naphthalene, phenanthrene, pyrene, tetracene, coronene, chrysene, fluoresceine, perylene, phthaloperylene, naphthaloperylene, perynone, phthaloperynone, naphthaloperynone, diphenylbutadiene, tetraphenylbutadiene, coumarin, oxadizole, aldazine, bisbenzoxazoline, bisstyryl, pyrazine, cyclopentadiene, quinoline metal complex, aminoquinoline metal complex, benzoquinoline metal complex, imine, diphenylethylene, vinylanthracene, diaminocarbazole, pyrane, thiopyran, polymethine, merocyanine, imidazole chelated oxynoid compound, quinacridon, rubrene, fluorescent dye, and the like can be given. Note that the material for the emitting layer is not limited thereto.

It is preferred that the emitting layer contain either one or both of the arylamine compound and the styrylamine compound.

As examples of the arylamine compound, a compound of the following formula (A) can be given. As examples of the styrylamine compound, a compound of the following formula (B) can be given.

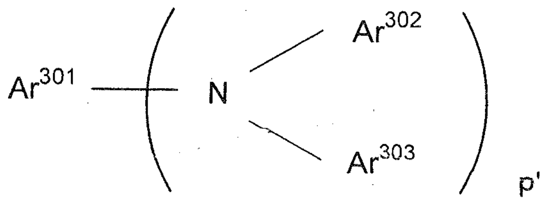

(A)

wherein $Ar^{301}$ is phenyl, biphenyl, terphenyl, stilbene or distyrylaryl; $Ar^{302}$ and $Ar^{303}$ are independently a hydrogen atom or a substituted or unsubstituted aromatic group having 6 to 20 carbon atoms; and p' is an integer of 1 to 4. It is further preferred that either one or both of $Ar^{302}$ and $Ar^{303}$ be substituted with a styryl group group.

As the aromatic group having 6 to 20 carbon atoms, phenyl, naphthyl, anthracenyl, phenanthryl, terphenyl, and the like are preferable.

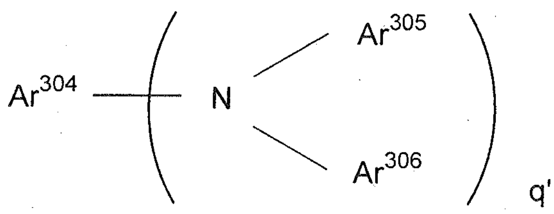

(B)

wherein $Ar^{304}$ to $Ar^{306}$ are independently a substituted or unsubstituted aryl group having 5 to 40 atoms forming a ring (hereinafter referred to as "nucleus atoms"); and q' is an integer of 1 to 4.

As the aryl groups having 5 to 40 ring atoms, phenyl, naphthyl, anthracenyl, phenanthryl, pyrenyl, chrycenyl, coronenyl, biphenyl, terphenyl, pyrrolyl, furanyl, thiophenyl, benzothiophenyl, oxadiazolyl, diphenylanthracenyl, indolyl, carbazolyl, pyridyl, benzoquinolyl, fluoranthenyl, acenaphthofluoranthenyl, stilbene, and the like are preferable. The aromatic group having 5 to 40 ring carbon atoms may be further substituted with a substituent. Given as preferred substituents are alkyl groups having 1 to 6 carbon atoms (e.g. ethyl group, methyl group, i-propyl group, n-propyl group, s-butyl group, t-butyl group, pentyl group, hexyl group, cyclopentyl group, and cyclohexyl group), alkoxy groups having 1 to 6 carbon atoms (e.g. ethoxy group, methoxy group, i-propoxy group, n-propoxy group, s-butoxy group, t-butoxy group, pentoxy group, hexyloxy group, cyclopentoxy group, and cyclohexyloxy group), aryl groups having 5 to 40 ring atoms, amino groups substituted with an aryl group having 5 to 40 ring atoms, ester groups containing an aryl group having 5 to 40 ring atoms, ester groups containing an alkyl group having 1 to 6 carbon atoms, cyano group, nitro group, and halogen atoms (e.g. chlorine, bromine, and iodine).

Preferable examples of the host material which can be used in the emitting layer include aromatic ring compounds shown by the formulas (1) to (10), which are used in the electron-transporting layer mentioned later.

Among the above host materials, the anthracene derivatives are preferable. The monoanthracene derivatives are more preferable, with the asymmetrical anthracene being particularly preferable.

Phosphorescent compounds can be used as the dopant material. In the case of phosphorescence emission, it is preferable to use a compound such as a carbazole-ring containing compound or a nitrogen-containing heterocyclic compound is preferably used as the host material. A phosphorescent dopant is a compound that can emit light from triplet excitons, and there are no specific restrictions on the type thereof insofar as it can emit light from triplet excitons, but it is preferably a metal complex containing at least one metal selected from the group of Ir, Ru, Pd, Pt, Os, Cu and Re.

The compound containing a carbazole ring, which is a host suitable for phosphorescence emission, is a compound which allows a phosphorescent compound to emit as a result of energy transfer from its excited state to the

phosphorescent compound. The host compound is not limited so long as the compound can transfer its excited energy to a phosphorescent compound and it can be selected depending on purposes. The host compound may contain any heterocyclic ring other than a carbazole ring.

Specific examples of the host compounds include carbazole, triazole, oxazole, oxadiazole, imidazole, polyarylalkane, pyrazoline, pyrazolone, phenylanediamine, arylamine, amino-substituted calcone, styryl anthracene, fluorenone, hydrazone, stilbene and silazane derivatives; aromatic tertiary amine, styrylamine, aromatic dimethylidene and porphyrin compounds; anthraquinodimethane, anthrone, diphenylquinone, thiopyrandioxide, carbodiimide, fluoreniridenemethane and distyrylpyrazine derivatives; heterocyclic tetracarboxylic anhydrides such as naphthaleneperylene; phthalocyanine derivatives; metal complexes of 8-quinolinol derivatives; various metal complex polysilane compounds represented by metal complexes having metalphthalocyanine, benzoxazole or benzothiaole as a ligand; electroconductive macromolecular oligomers such as poly(N-vinylcarbazole) derivatives, aniline copolymers, thiophene oligomers and polythiophene; and polymer compounds such as polythiophene, polyphenylene, polyphenylenevinylene and polyfluorene derivatives. The host compounds may be used either singly or in combination of two or more.

Specific examples include the compounds shown by the following formula and satisfy the above-mentioned relationship of the electron mobility and the hole mobility. However, the specific examples are not limited to these compounds insofar as the compound satisfies the above-mentioned relationship. Hole-transporting materials and electron-transporting materials may be mixed such that the above-mentioned relationship can be satisfied.

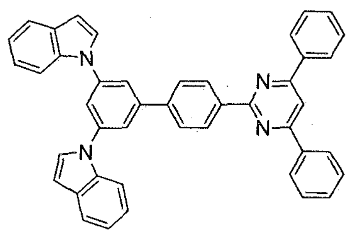
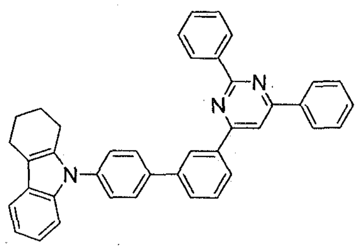
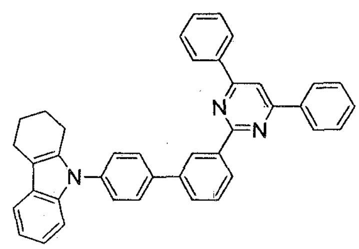

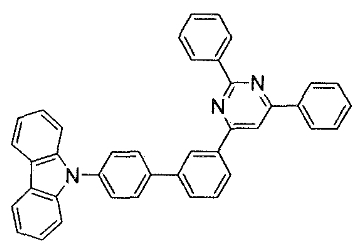
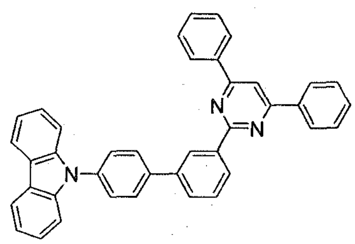
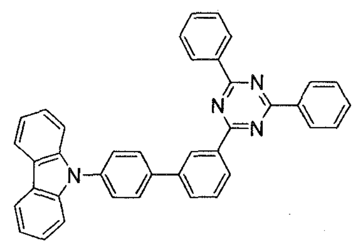

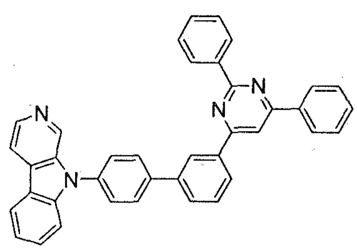
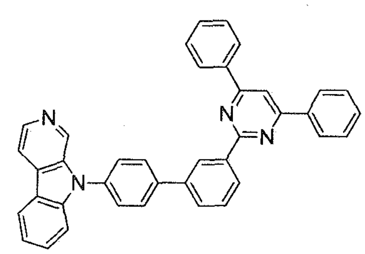
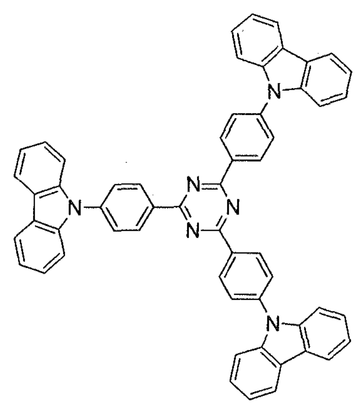

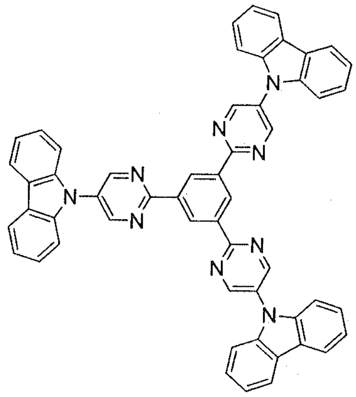
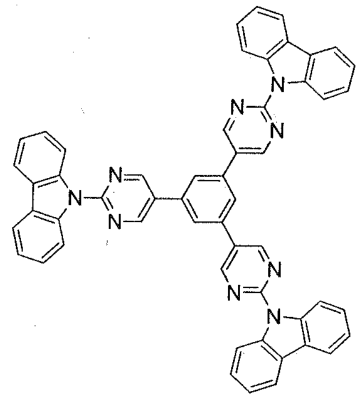
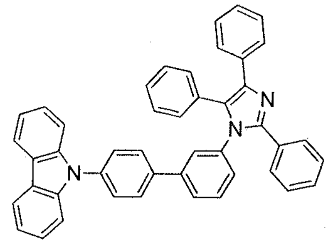

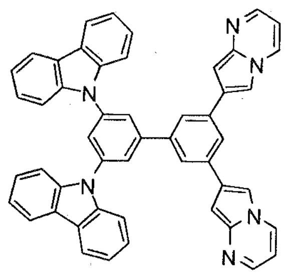
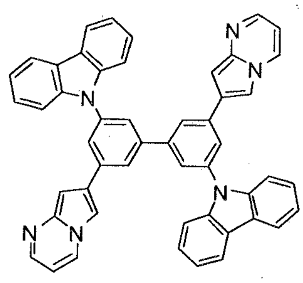
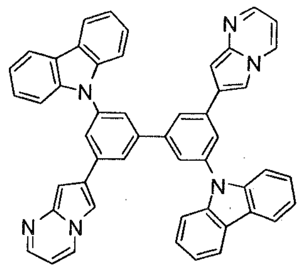

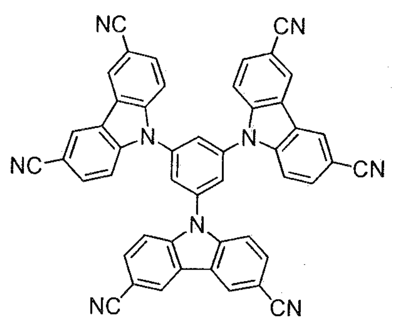
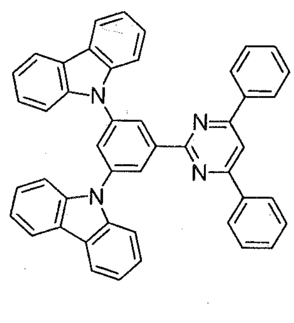
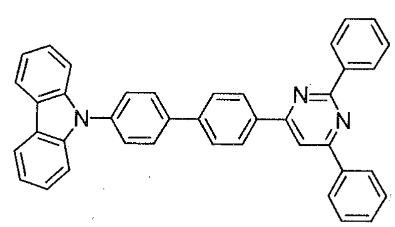

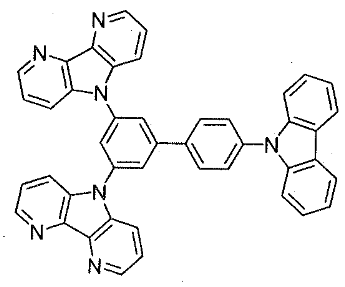 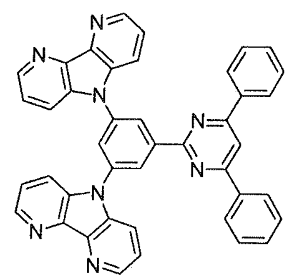 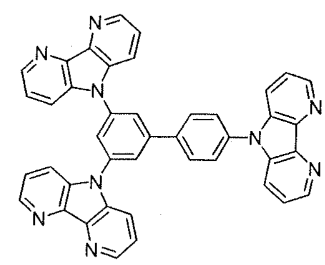

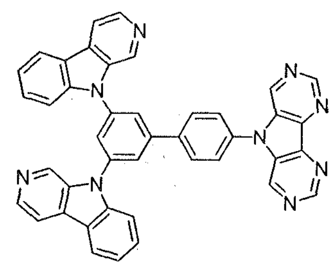

A phosphorescent dopant is a compound that can emit light from triplet excitons. The dopant is not limited so long as it can emit light from triplet excitons, but it is preferably a metal complex containing at least one metal selected from the group of Ir, Ru, Pd, Pt, Os, Cu and Re. A porphyrin metal complex or an ortho-metalated metal complex is preferable. As a porphyrin metal complex, a porphyrin platinum complex is preferable. Phosphorescent compounds may be used either singly or in combination of two or more.

There are various ligands forming an ortho-metalated metal complex. Preferable ligands include 2-phenylpyridine, 7,8-benzoquinoline, 2-(2-thienyl)pyridine, 2-(1-naphtyl)pyridine and 2-phenylquinoline derivatives. These derivatives may have substituents, if necessary. Fluorides and derivatives with a trifluoromethyl group introduced are particularly preferable as a blue dopant. As an auxiliary ligand, preferred are ligands other than the above-mentioned ligands, such as acetylacetonate and picric acid may be contained.

The content of a phosphorescent dopant in an emitting layer is not limited and can be properly selected according to purposes; for example, it is 0.1 to 70 mass %, preferably 1 to 30 mass %. When the content of a phosphorescent compound is less than 0.1 mass %, emission may be weak and the advantages thereof may not be sufficiently obtained. When the content exceeds 70 mass %, the phenomenon called concentration quenching may significantly proceed, thereby degrading the device performance.

The emitting layer may contain hole-transporting materials, electron-transporting materials and polymer binders, if necessary.

The thickness of the emitting layer is preferably 20 nm or more. If the thickness of the emitting layer is less than 20 nm, triplet excitons tend to collide with each other or tend to diffuse to adjacent or remote organic layers, whereby luminous efficiency may be decreased.

[Hole-transporting (injecting/transporting) layer (hole-transporting region)]

On the anode side of the emitting layer, a hole-transporting layer may be further stacked. The hole-transporting layer is a layer for helping the injection of holes into the emitting layer so as to transport holes to an emitting region. The hole mobility thereof is large and the ionization energy thereof is usually as small as 5.5 eV or less. Such a hole-transporting layer is preferably made of a material which can transport holes to the emitting layer at a low electric field intensity. Furthermore, it is preferred that the hole mobility be at least $10^{-4}$ $cm^2/V{\cdot}sec$ when an electronic field of $10^4$ to $10^6$ V/cm is applied.

Any materials which have the above preferable property can be used as the material for forming the hole-transporting layer without particular limitation. The material for forming the hole-transporting layer can be arbitrarily

selected from materials which have been widely used as a material transporting carriers of holes in photoconductive materials and known materials used in a hole-injecting layer of organic EL devices.

Specific examples include triazole derivatives (see USP No. 3,112,197 and others), oxadiazole derivatives (see USP No. 3,189,447 and others), imidazole derivatives (see JP-B-37-16096 and others), polyarylalkane derivatives (see USP Nos. 3,615,402, 3,820,989 and 3,542,544, JP-B-45-555 and 51-10983, JP-A-51-93224, 55-17105, 56-4148, 55-108667, 55-156953 and 56-36656, and others), pyrazoline derivatives and pyrazolone derivatives (see USP Nos, 3, 180, 729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, 54-119925, and others), arylamine derivatives (see USP Nos. 3,567,450, 3,240,597, 3,658,520, 4,232,103, 4,175,961 and 4,012,376, JP-B-49-35702 and 39-27577, JP-A-55-144250, 56-119132 and 56-22437, DE1,110,518, and others), amino-substituted chalcone derivatives (see USP No. 3,526,501, and others), oxazole derivatives (ones disclosed in USP No. 3, 257, 203, and others), styrylanthracene derivatives (see JP-A-56-46234, and others), fluorenone derivatives (JP-A-54-110837, and others), hydrazone derivatives (see USP Nos. 3,717,462, JP-A-54-59143, 55-52063, 55-52064, 55-46760, 57-11350, 57-148749 and 2-311591, and others), stilbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950,950), polysilanes (JP-A-2-204996), aniline copolymers (JP-A-2-282263), and electroconductive high molecular oligomers.

The above-mentioned substances can be used as the material of the hole-transporting layer. The following can also be used: porphyrin compounds (disclosed in JP-A-63-2956965 and others), aromatic tertiary amine compounds and styrylamine compounds (see USP No. 4,127,412, JP-A-53-27033, 54-58445, 54-149634, 54-64299, 55-79450, 55-144250, 56-119132, 61-295558, 61-98353 and 63-295695, and others). In particular, aromatic tertiary amine compounds are preferable.

As the hole-transporting material which can be used in the hole-transporting layer, compounds shown by the following formula are preferable.

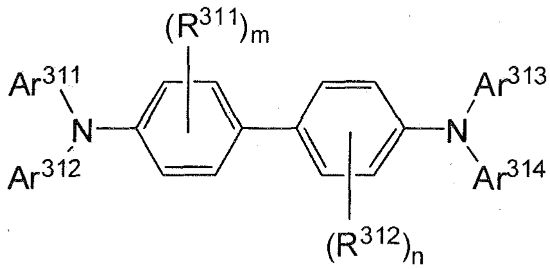

wherein $Ar^{311}$ to $Ar^{314}$ are independently a substituted or unsubstituted aryl group having 6 to 50 carbon atoms forming a ring (hereinafter referred to as "ring carbon atoms"), $R^{311}$ and $R^{312}$ are independently a hydrogen atom, a substituted and unsubstituted aryl group having 6 to 50 ring carbon atoms or an alkyl group having 1 to 50 carbon atoms; and m and n are each an integer of 0 to 4. $Ar^{311}$ to $Ar^{314}$ may be bonded to each other to form a ring. For example, at least one of -N ($Ar^{311}$) $Ar^{312}$ and -N($Ar^{313}$)$Ar^{314}$ may be carbazolyl, benzocarbazolyl, azacarbazolyl, benzoazacarbazolyl, phenoxadinyl, phenothiadinyl or the like.

Examples of the aryl group having 6 to 50 ring carbon atoms preferably include phenyl, naphthyl, biphenyl, terphenyl and phenanthryl group. The aryl group having 6 to 50 ring carbon atoms may be substituted by a substituent. As preferable examples of the substituent, alkyl groups having 1 to 6 carbon atoms (methyl, ethyl, isopropyl, n-propyl, s-butyl, t-butyl, pentyl, hexyl, cyclopentyl, cyclohexyl and the like) and amino groups substituted by an aryl group having 6 to 50 ring carbon atoms can be given.

The following can also be given as examples:

4,4'-bis(N-(1-naphthyl)-N-phenylamino)biphenyl (hereinafter abbreviated as "NPD"), which has in the molecule thereof two condensed aromatic rings, disclosed in USP No. 5,061,569, and
4,4',4"-tris(N-(3-methylphenyl)-N-phenylamino)triphenylamin e (hereinafter abbreviated as "MTDATA") or
4,4',4"-tris(carbazolyl-9-yl)-triphenylamine, wherein three triphenylamine units are linked to each other in a star-burst form, disclosed in JP-A-4-308688.

Inorganic compounds such as p-type Si and p-type SiC as well as aromatic dimethylidene type compounds can also be used as the material of the hole-transporting layer.

The hole-transporting layer may be formed of a single layer formed of one or two or more of the above-mentioned

materials insofar as it has the above-mentioned compound in the hole-transporting region. The hole-transporting layer may be a stacked structure obtained by stacking a hole-transporting layer formed of a compound different from those used in the above-mentioned hole-transporting layer.

[Electron-transporting (injecting/transporting) layer (electron-transporting region)]

An electron-transporting layer may be further stacked on the cathode side of the emitting layer. The electron-transporting layer is a layer for helping the injection of electrons into the emitting layer, and has a large electron mobility. The thickness of the electron-transporting layer is selected from the range of several nm to several μm.
As the material used in the electron-transporting layer, a compound having a nitrogen-containing heterocycle is preferable.
As the compound containing a nitrogen-containing heterocycle, an oxadiazole derivative shown by the following general formula is given.
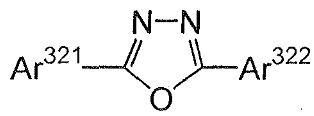

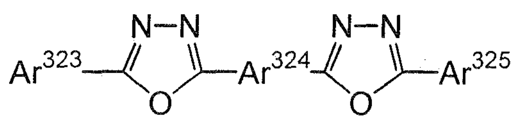

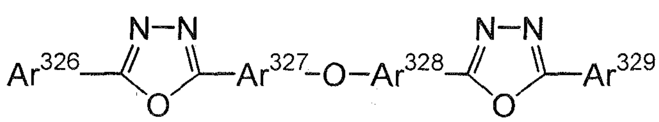

wherein Ar$^{321}$, Ar$^{322}$, Ar$^{323}$, Ar$^{325}$, Ar$^{326}$ and Ar$^{329}$ are independently a substituted or unsubstituted aryl group and may be the same or different. Ar$^{324}$, Ar$^{327}$ and Ar$^{328}$ are independently substituted or unsubstituted arylene groups and may be the same or different.
As examples of the aryl group, a phenyl group, a biphenyl group, an anthranyl group, a perylenyl group, and a pyrenyl group can be given. As examples of the arylene group, a phenylene group, a naphthylene group, a biphenylene group, an anthranylene group, a perylenylene group, a pyrenylene group, and the like can be given. As the substituent, an alkyl group having 1 to 10 carbon atoms, an alkoxy group having 1 to 10 carbon atoms, a cyano group, and the like can be given. The electron-transporting compound is preferably one from which a thin film can be formed.
The following compounds can be given as specific examples of the electron-transporting compound.
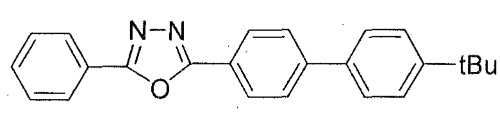

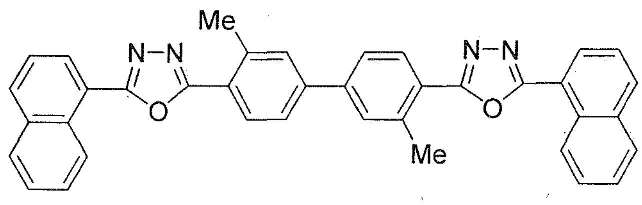

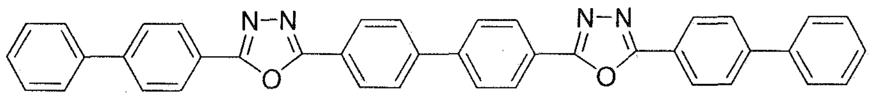

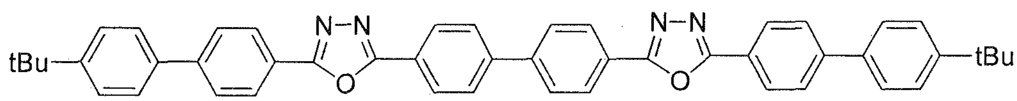

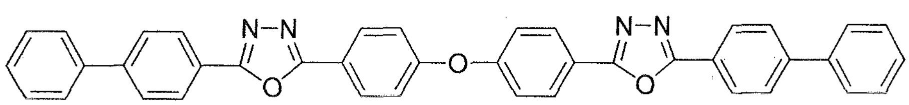

Me is methyl and Bu is butyl.

Other than the compounds given above, the following compounds can be exemplified as the compound containing a nitrogen-containing heterocycle.

Nitrogen-containing heterocyclic derivatives of the following formula:

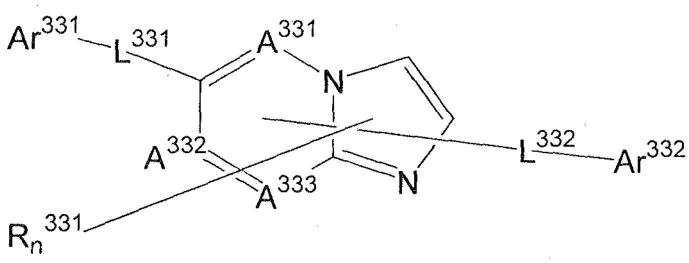

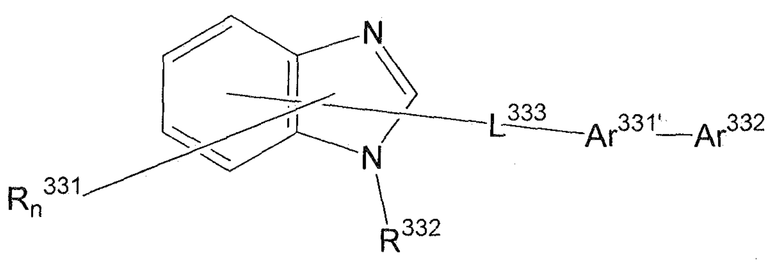

wherein $A^{331}$ to $A^{333}$ are a nitrogen atom or a carbon atom;

$R^{331}$ and $R^{332}$ are independently a substituted or unsubstituted aryl group having 6 to 60 carbon atoms, a substituted or unsubstituted heteroaryl group having 3 to 60 carbon atoms, an alkyl group having 1 to 20 carbon atoms, a

haloalkyl group having 1 to 20 carbon atoms, or an alkoxy group having 1 to 20 carbon atoms, and n is an integer of 0 to 5, provided that, when n is an integer of 2 or more, $R^{331}$s may be the same or different;
adjacent $R^{331}$s may be bonded to each other to form a substituted or unsubstituted carbocyclic aliphatic ring or a substituted or unsubstituted carbocyclic aromatic ring;
$Ar^{331}$ is a substituted or unsubstituted aryl group having 6 to 60 carbon atoms or a substituted or unsubstituted heteroaryl group having 3 to 60 carbon atoms;
$Ar^{331'}$ is a substituted or unsubstituted arylene group having 6 to 60 carbon atoms or a substituted or unsubstituted heteroarylene group having 3 to 60 carbon atoms;
$Ar^{332}$ is a hydrogen atom, an alkyl group having 1 to 20 carbon atoms, a haloalkyl group having 1 to 20 carbon atoms, an alkoxy group having 1 to 20 carbon atoms, a substituted or unsubstituted aryl group having 6 to 60 carbon atoms, or a substituted or unsubstituted heteroaryl group having 3 to 60 carbon atoms;
provided that one of $Ar^{331}$ and $Ar^{332}$ is a substituted or unsubstituted condensed ring group having 10 to 60 carbon atoms or a substituted or unsubstituted heterocondensed ring group having 3 to 60 carbon atoms; and
$L^{331}$, $L^{332}$ and $L^{333}$ are independently a single bond, a substituted or unsubstituted condensed ring group having 6 to 60 carbon atoms, a substituted or unsubstituted hetero-condensed ring having 3 to 60 carbon atoms or a substituted or unsubstituted fluorenylene group.

Nitrogen-containing heterocyclic derivatives shown by the following formula disclosed in JP-A-2004-002297: $HAr-L^{341}-Ar^{341}-Ar^{342}$ wherein HAr is a substituted or unsubstituted nitrogen-containing heterocycle having 3 to 40 carbon atoms,

$L^{341}$ is a single bond, a substituted or unsubstituted arylene group having 6 to 60 carbon atoms, a substituted or unsubstituted heteroarylene group having 3 to 60 carbon atoms or a substituted or unsubstituted fluorenylene group;
$Ar^{341}$ is a substituted or unsubstituted divalent aromatic hydrocarbon group having 6 to 60 carbon atoms, and
$Ar^{342}$ is a substituted or unsubstituted aryl group having 6 to 60 carbon atoms or a substituted or unsubstituted heteroaryl group having 3 to 60 carbon atoms.

Silacyclopentadiene derivatives shown by the following formula disclosed in JP-A-09-087616

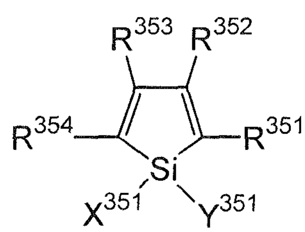

wherein $X^{351}$ and $Y^{351}$ are independently a saturated or unsaturated hydrocarbon, alkoxy, alkenyloxy, alkynyloxy or hydroxyl group having 1 to 6 carbon atoms, a substituted or unsubstituted aryl group, or a substituted or unsubstituted heterocycle, or $X^{351}$ and $Y^{351}$ are bonded to each other to form a saturated or unsaturated ring; $R^{351}$ to $R^{354}$ are independently hydrogen, halogen, a saturated or unsaturated alkyl group having 1 to 6 carbon atoms, an alkoxy group, an aryloxy group, a perfluoroalkyl group, a perfluoroalkoxy group, an amino group, an alkylcarbonyl group, an arylcarbonyl group, an alkoxycarbonyl group, an aryloxycarbonyl group, an azo group, an alkylcarbonyloxy group, an arylcarbonyloxy group, an alkoxycarbonyloxy group, an aryloxycarbonyloxy group, a sulfinyl group, a sulfonyl group, a sulfanyl group, a silyl group, a carbamoyl group, an aryl group, a heterocyclic group, an alkenyl group, an alkynyl group, a nitro group, a formyl group, a nitroso group, a formyloxy group, an isocyano group, a cyanate group, an isocyanate group, a thiocyanate group, an isothiocyanate group or a cyano group, or, when substituted or unsubstituted rings are adjacent to each other, the rings are condensed with each other.
Silacylcopentadiene derivative shown by the following formula disclosed in JP-A-09-194487

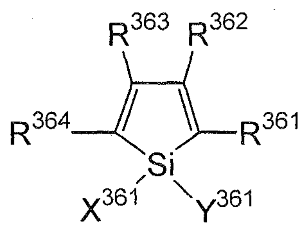

wherein $X^{361}$ and $Y^{361}$ are independently a saturated or unsaturated hydrocarbon, alkoxy, alkenyloxy, or alkynyloxy group having 1 to 6 carbon atoms, a substituted or unsubstituted aryl group, or a substituted or unsubstituted heterocycle, or $X^{361}$ and $Y^{361}$ are bonded to each other to form a saturated or unsaturated ring, $R^{361}$ to $R^{364}$ are independently hydrogen, halogen, a substituted or unsubstituted alkyl group having 1 to 6 carbon atoms, an alkoxy group, an aryloxy group, a perfluoroalkyl group, a perfluoroalkoxy group, an amino group, an alkylcarbonyl group, an arylcarbonyl group, an alkoxycarbonyl group, an aryloxycarbonyl group, an azo group, an alkylcarbonyloxy group, an arylcarbonyloxy group, an alkoxycarbonyloxy group, an aryloxycarbonyloxy group, a sulfinyl group, a sulfonyl group, a sulfanyl group, a silyl group, a carbamoyl group, an aryl group, a heterocyclic group, an alkenyl group, an alkynyl group, a nitro group, a formyl group, a nitroso group, a formyloxy group, an isocyano group, a cyanate group, an isocyanate group, a thiocyanate group, an isothiocyanate group, or a cyano group, or, when substituted or unsubstituted rings shown by two arbitrary symbols of $R^{361}$ to $R^{364}$ are adjacent to each other, the rings are condensed with each other (provided that when $R^{361}$ and $R^{364}$ are phenyl, $X^{361}$ and $Y^{361}$ are not alkyl and phenyl, when $R^{361}$ and $R^{364}$ are thienyl, a state where $X^{361}$ and $Y^{361}$ are a monovalent hydrocarbon group, and a state where $R^{362}$ and $R^{363}$ are independently alkyl, aryl, alkenyl, or $R^{362}$ and $R^{363}$ are an aliphatic group to be bonded to each other to form a ring are not simultaneously satisfied, and when $R^{361}$ and $R^{364}$ are silyl, $R^{362}$, $R^{363}$, $X^{361}$ and $Y^{361}$ are not independently a monovalent hydrocarbon group having 1 to 6 carbon atoms or a hydrogen atom, and when a benzene ring is condensed at $R^{361}$ and $R^{362}$, $X^{361}$ and $Y^{361}$ are not alkyl and phenyl.

Borane derivatives shown by the following formula disclosed in WO00/40586

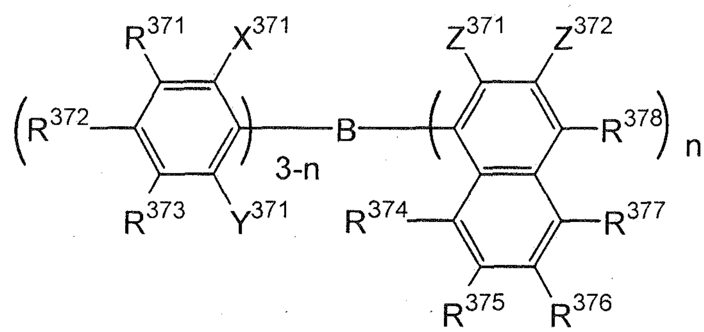

wherein $R^{371}$ to $R^{378}$ and $Z^{372}$ are independently a hydrogen atom, a saturated or unsaturated hydrocarbon group, an aromatic group, a heterocyclic group, a substituted amino group, a substituted boryl group, an alkoxy group, or an aryloxy group, $X^{371}$, $Y^{371}$, and $Z^{371}$ are independently a saturated or unsaturated hydrocarbon group, an aromatic group, a heterocyclic group, a substituted amino group, an alkoxy group, or an aryloxy group, the substituents for $Z^{371}$ and $Z^{372}$ may be bonded to each other to form a condensed ring, n is an integer of 1 to 3, provided that the $Z^{371}$s may differ when n is 2 or more, and a case in which n is 1, $X^{371}$, $Y^{371}$ and $R^{372}$ are methyl groups, and $R^{378}$ is a hydrogen atom or a substituted boryl group, and a case in which n is 3 and $Z^{371}$ is a methyl group are excluded.

Compounds shown by the following formula disclosed in JP-A-H10-088121

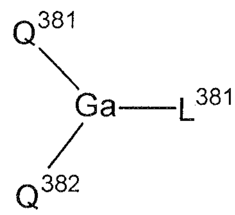

wherein $Q^{381}$ and $Q^{382}$ are independently ligands of the following formula, $L^{381}$ is a halogen atom, a substituted or unsubstituted alkyl group, a substituted or unsubstituted cycloalkyl group, a substituted or unsubstituted aryl group, a substituted or unsubstituted heterocyclic group, $-OR^{391}$ ($R^{391}$ is a hydrogen atom, a substituted or unsubstituted alkyl group, a substituted or unsubstituted cycloalkyl group, a substituted or unsubstituted aryl group, or a substituted or unsubstituted heterocyclic group), or a ligand shown by $-O-Ga-Q^{391}(Q^{392})$ ($Q^{391}$ and $Q^{392}$ have the same meanings as $Q^{381}$ and $Q^{382}$).

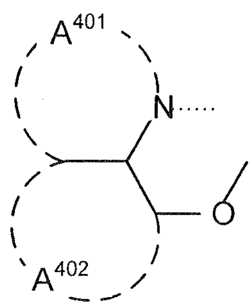

wherein the ring $A^{401}$ and the ring $A^{402}$ are substituted or unsubstituted aryl ring structures or heterocyclic structures which are bonded to each other.

Specific examples of the substituent of the rings $A^{401}$ and $A^{402}$ each forming the ligand in the above formula include a halogen atom such as chlorine, bromine, iodine, and fluorine; a substituted or unsubstituted alkyl group such as a methyl group, an ethyl group, a propyl group, a butyl group, a sec-butyl group, a tert-butyl group, a pentyl group, a hexyl group, a heptyl group, an octyl group, a stearyl group and a trichloromethyl group; a substituted or unsubstituted aryl group such as a phenyl group, a naphthyl group, a 3-methylphenyl group, a 3-methoxyphenyl group, a 3-fluorophenyl group, a 3-trichloromethylphenyl group, a 3-trifluoromethylphenyl group and a 3-nitrophenyl group; a substituted and unsubstituted alkoxy group such as a methoxy group, an n-butoxy group, a tert-butoxy group, a trichloromethoxy group, a trifluoroethoxy group, a pentafluoropropoxy group, a 2,2,3,3-tetrafluoropropoxy group, a 1,1,1,3,3,3-hexafluoro-2-propoxy group and a 6-(perfluoroethyl)hexyloxy group; a substituted or unsubstituted aryloxy group such as a phenoxy group, a p-nitrophenoxy group, a p-tert-butylphenoxy group, a 3-fluorophenoxy group, a pentafluorophenyl group, and a 3-trifluoromethylphenoxy group; substituted or unsubstituted alkylthio groups such as a methylthio group, an ethylthio group, a tert-butylthio group, a hexylthio group, an octylthio group, and a trifluoromethylthio group; a substituted or unsubstituted arylthio group such as a phenylthio group, a p-nitrophenylthio group, a ptert-butylphenylthio group, a 3-fluorophenylthio group, a pentafluorophenylthio group, and a 3-trifluoromethylphenylthio group; a mono- or di-substituted amino group such as a cyano group, a nitro group, an amino group, a methylamino group, a diethylamino group, an ethylamino group, a diethylamino group, a dipropylamino group, a dibutylamino group and a diphenylamino group; an acylamino group such as a bis (acetoxymethyl) amino group, a bis (acetoxyethyl) amino group, a bis (acetoxypropyl) amino group and a bis(acetoxybutyl)amino group; a hydroxy group; a siloxy group; an acyl group; a carbamoyl group such as a methylcarbamoyl group, a dimethylcarbomoyl group, an ethylcarbamoyl group, a diethylcarbamoyl group, a propylcarbamoyl group, a butylcarbamoyl group, and a phenylcarbamoyl group; a carboxyl group; a sulfone group; an imide group; a cycloalkyl group such as a cyclopentane group and a cyclohexyl group; an aryl group such as a phenyl group, a naphthyl group, a biphenyl group, an anthranyl group, a phenanthryl group, a fluorenyl group and a pyrenyl group; a heterocyclic group such as a pyridinyl group, a pyrazinyl group, a pyrimidinyl group, a pyridazinyl group, a triazinyl group, an indolinyl group, a quinolinyl group, an acridinyl group, a pyrrolidinyl group, a dioxanyl group, a piperidinyl group, a morpholidinyl group, a piperazinyl group, a carbazolyl group, a furanyl group, a thiophenyl group, an oxazolyl group, an oxadiazolyl group, a benzooxazolyl group, a thiazolyl group, a thiadiazolyl group, a benzothiazolyl group, a triazolyl group, an imidazolyl group, and a benzoimidazolyl group. In addition, the above-mentioned substituents may

be bonded to each other to form a 6-membered aryl ring or a heterocyclic ring.

As the nitrogen-containing compound, a condensed aromatic ring derivative containing an electron-deficient nitrogen-containing five-membered ring or a condensed aromatic ring derivative containing an electron-deficient nitrogen-containing six-membered ring are particularly preferable.

Preferred examples of the $\pi$ electron-deficient nitrogen-containing ring include a derivative of a nitrogen-containing five-membered ring selected from an imidazole ring, a triazole ring, a tetrazole ring, an oxadiazole ring, a thiadiazole ring, an oxatriazole ring and a thiatriazole ring or a derivative of a nitrogen-containing six-membered ring selected from a quinoxaline ring, a quinoline ring, a quinazoline ring, a pyridine ring, a pyrazine ring and a pyrimidine ring.

In addition, a compound including an aromatic ring compound may be used in the electron-transporting layer. It is preferred that the electron-transporting layer contain a compound having an anthracene derivative.
Specific examples of the compound are shown below.

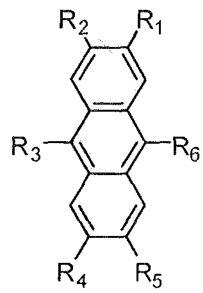

wherein $R_1$ to $R_6$ are independently a hydrogen atom, a substituted or unsubstituted alkyl group having 1 to 40 carbon atoms, a substituted or unsubstituted perfluoroalkyl group having 1 to 40 carbon atoms, a substituted or unsubstituted alkoxy group having 1 to 40 carbon atoms, a substituted or unsubstituted aralkyl group having 1 to 40 carbon atoms, a substituted or unsubstituted arylalkoxy group having 1 to 40 carbon atoms, a substituted or unsubstituted aryl group having 6 to 80 carbon atoms, a substituted or unsubstituted heterocyclic group having 3 to 80 carbon atoms, a substituted or unsubstituted alkylsilyl group having 1 to 40 carbon atoms, a substituted or unsubstituted arylsilyl group having 6 to 80 carbon atoms, a cyano group or diarylphosphine oxide, provided that groups adjacent to each other may form a ring.

Specific examples thereof are given below.

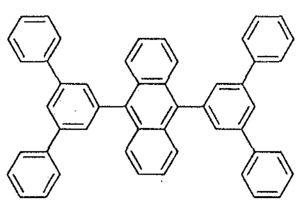

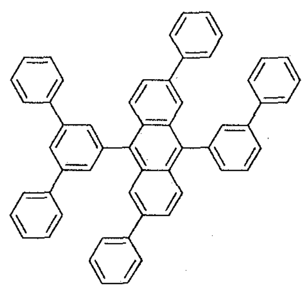

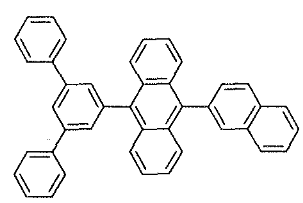

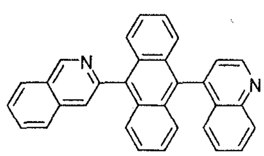

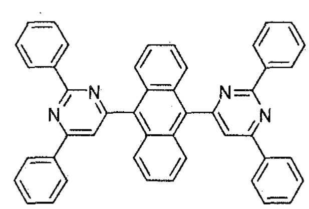

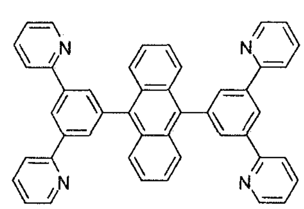

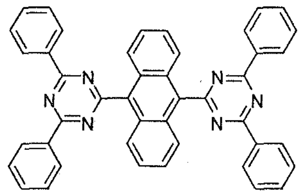
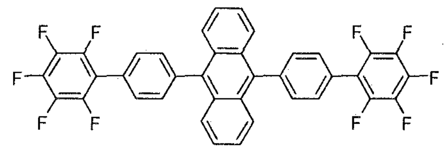

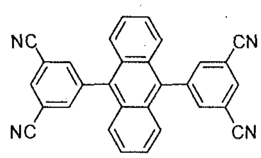
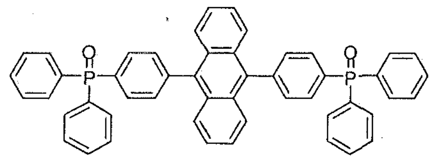

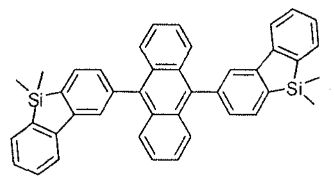
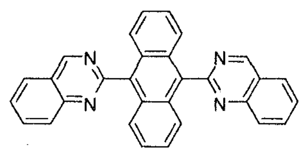

Furthermore, as the compound having an anthracene skeleton, the following compounds can be exemplified.

HAr -L - Ar$^1$ - Ar$^2$

| HAr | L | Ar$^1$ | Ar$^2$ |
|---|---|---|---|
| 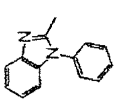 | 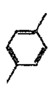 | 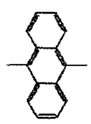 | 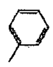 |
| 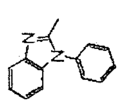 | 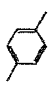 | 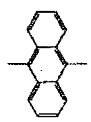 | 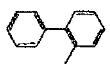 |
| 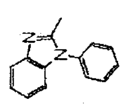 | 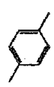 | 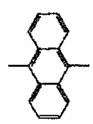 | 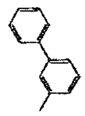 |
| 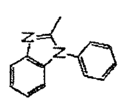 | 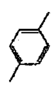 | 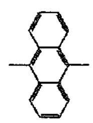 | 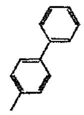 |
| 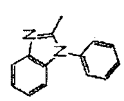 | 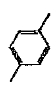 | 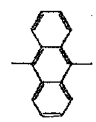 | 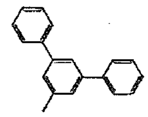 |
| 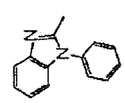 | 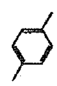 | 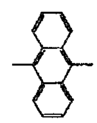 | 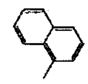 |
| 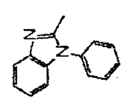 | 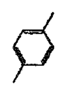 | 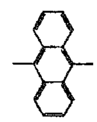 | 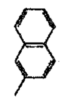 |
| 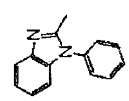 | 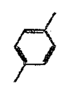 | 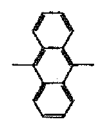 | 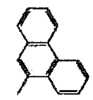 |

(continued)

HAr -L - $Ar^1$ - $Ar^2$

| | | | | | | | |
|---|---|---|---|---|---|---|---|
| $Ar^2$ | 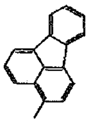 | 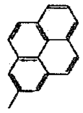 | 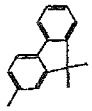 | 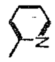 | 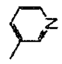 | 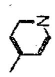 | 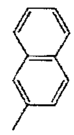 |
| $Ar^1$ | 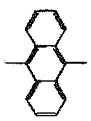 | 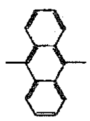 | 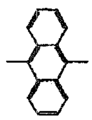 | 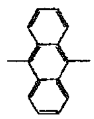 | 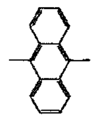 | 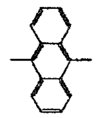 | 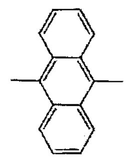 |
| L | 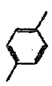 | 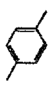 | 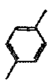 | 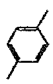 | 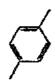 | 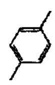 | 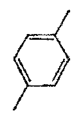 |
| HAr | 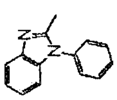 | 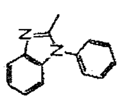 | 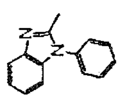 | 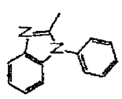 | 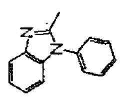 | 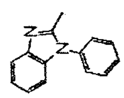 | 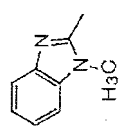 |

(continued)

HAr -L - Ar1 - Ar2

| HAr | L | $Ar^1$ | $Ar^2$ |
| --- | --- | --- | --- |
| 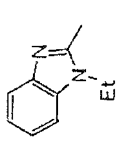 | 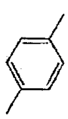 | 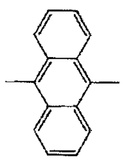 | 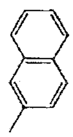 |
| 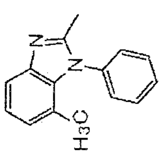 | 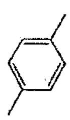 | 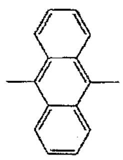 | 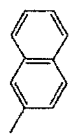 |
| 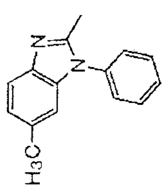 | 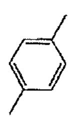 | 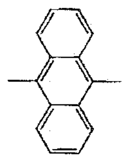 | 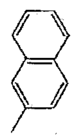 |
| 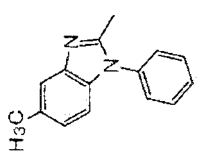 | 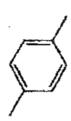 | 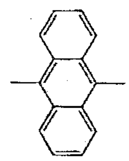 | 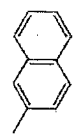 |
| 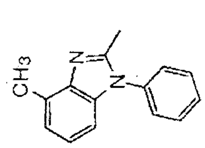 | 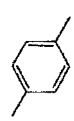 | 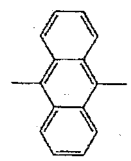 | 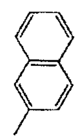 |

(continued)

HAr -L - $Ar^1$ - $Ar^2$

| HAr | L | $Ar^1$ | $Ar^2$ |
|---|---|---|---|
| 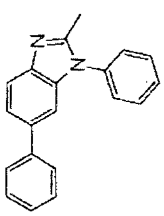 | 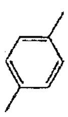 | 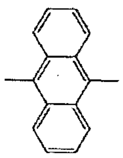 | 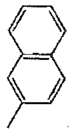 |
| 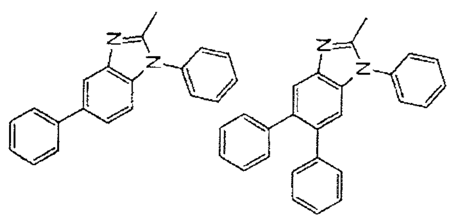 | 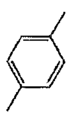 | 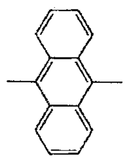 | 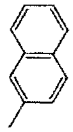 |
| | 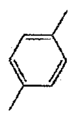 | 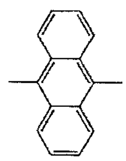 | 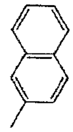 |
| 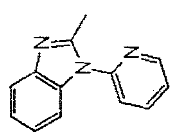 | 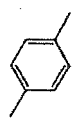 | 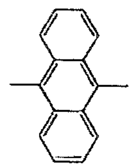 | 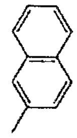 |

(continued)

HAr -L - $Ar^1$ - $Ar^2$

| HAr | L | $Ar^1$ | $Ar^2$ |
|---|---|---|---|
| 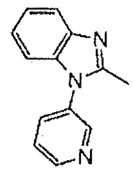 | 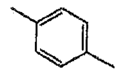 | 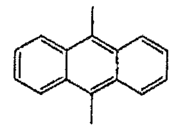 | 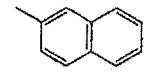 |
| 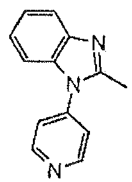 | 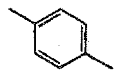 | 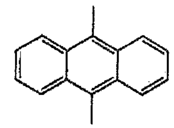 | 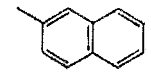 |
| 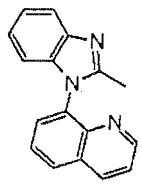 | 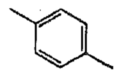 | 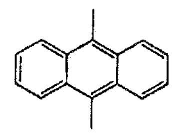 | 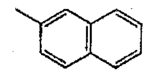 |
| 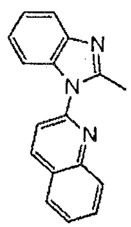 | 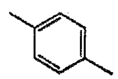 | 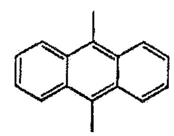 | 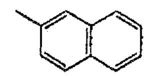 |

(continued)

HAr -L - $Ar^1$ - $Ar^2$

| | | | | | | |
|---|---|---|---|---|---|---|
| $Ar^2$ | 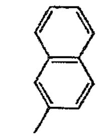 | 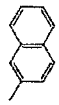 | 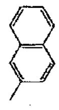 | 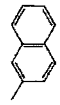 | 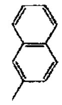 | 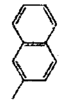 |
| $Ar^1$ | 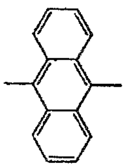 | 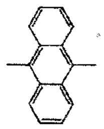 | 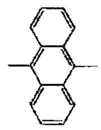 | 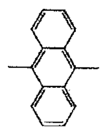 | 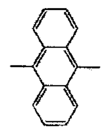 | 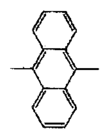 |
| L | 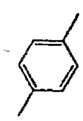 | 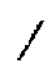 | 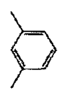 | 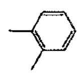 | 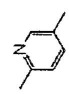 | 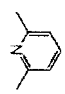 |
| HAr | 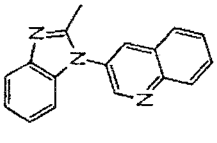 | 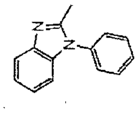 | 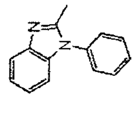 | 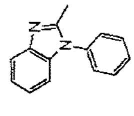 | 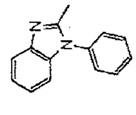 | 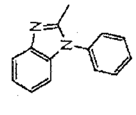 |

(continued)

HAr -L - $Ar^1$ - $Ar^2$

| HAr | L | $Ar^1$ | $Ar^2$ |
|---|---|---|---|
| 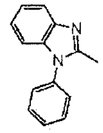 | 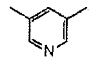 | 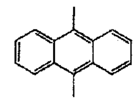 | 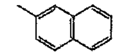 |
| 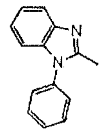 | 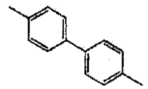 | 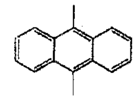 | 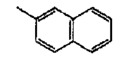 |
| 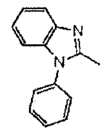 | 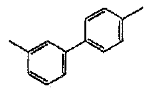 | 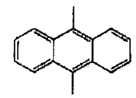 | 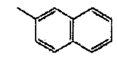 |
| 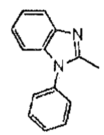 | 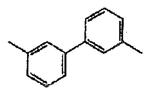 | 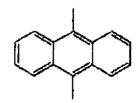 | 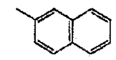 |
| 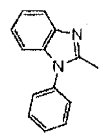 | 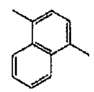 | 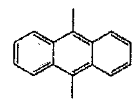 | 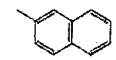 |
| 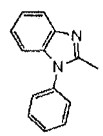 | 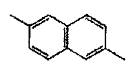 | 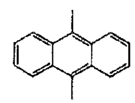 | 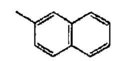 |

(continued)

$HAr - L - Ar^1 - Ar^2$

| HAr | L | $Ar^1$ | $Ar^2$ |
|---|---|---|---|
| 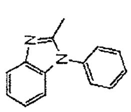 | 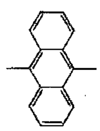 | 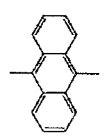 | 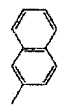 |
| 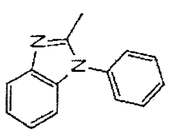 | 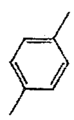 | 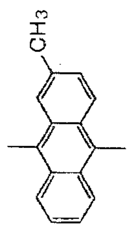 | 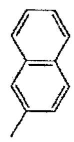 |
| 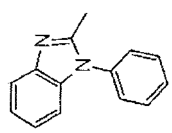 | 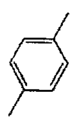 | 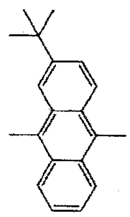 | 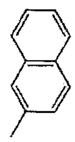 |
| 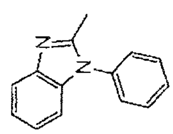 | 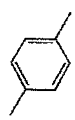 | 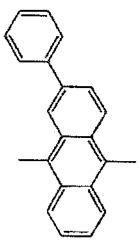 | 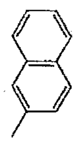 |
| 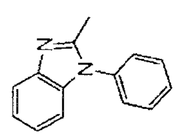 | 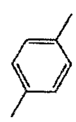 | 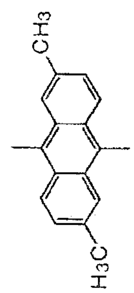 | 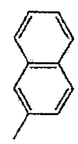 |

(continued)

| HAr -L - Ar[1] - Ar[2] | | | |
|---|---|---|---|
| HAr | L | $Ar^1$ | $Ar^2$ |
| 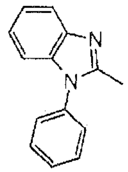 | 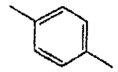 | 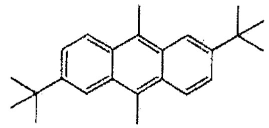 | 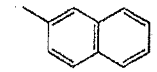 |
| 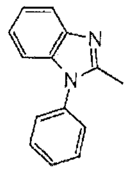 | 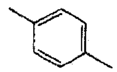 | 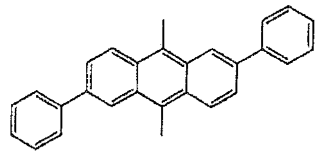 | 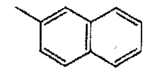 |
| 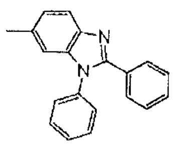 | 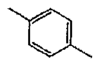 | 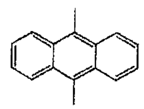 | 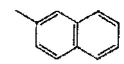 |
| 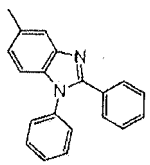 | 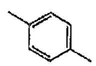 | 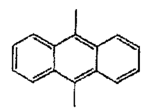 | 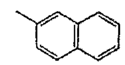 |
| 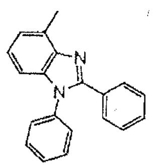 | 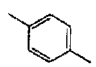 | 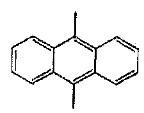 | 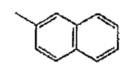 |

(continued)

HAr -L - $Ar^1$ - $Ar^2$

| HAr | L | $Ar^1$ | $Ar^2$ |
|---|---|---|---|
| 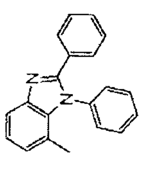 | 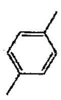 | 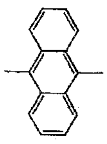 | 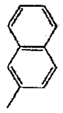 |
| 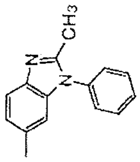 | 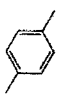 | 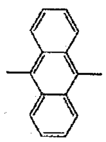 | 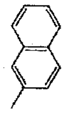 |
| 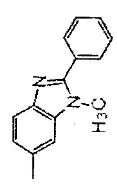 | 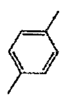 | 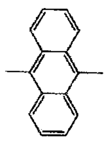 | 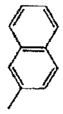 |
| 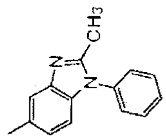 | 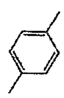 | 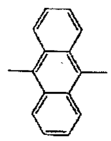 | 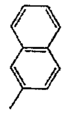 |
| 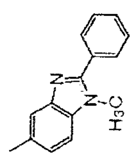 | 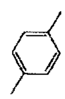 | 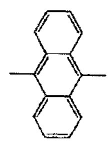 | 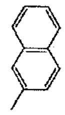 |

(continued)

HAr -L - $Ar^1$ - $Ar^2$

| HAr | L | $Ar^1$ | $Ar^2$ |
|---|---|---|---|
| 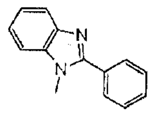 | 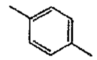 | 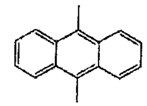 | 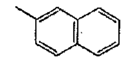 |
| 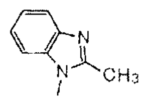 | 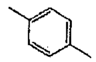 | 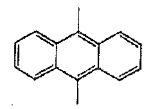 | 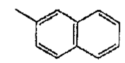 |
| 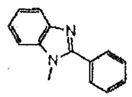 | 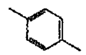 | 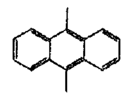 | 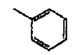 |
| 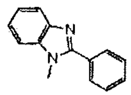 | 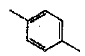 | 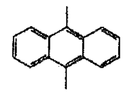 | 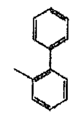 |
| 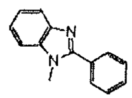 | 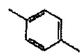 | 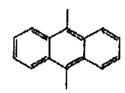 | 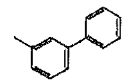 |
| 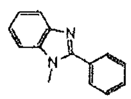 | 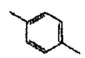 | 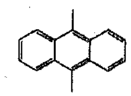 | 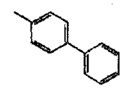 |
| 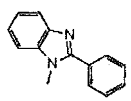 | 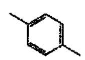 | 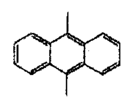 | 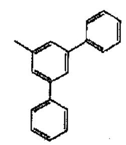 |

(continued)

HAr -L - $Ar^1$ - $Ar^2$

| HAr | L | $Ar^1$ | $Ar^2$ |
|---|---|---|---|
| 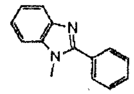 | 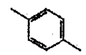 | 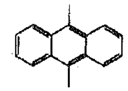 | 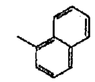 |
| 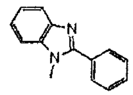 | 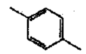 | 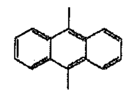 | 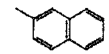 |
| 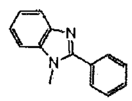 | 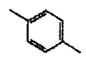 | 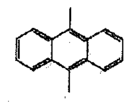 | 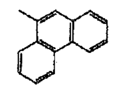 |
| 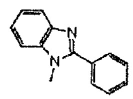 | 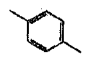 | 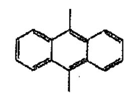 | 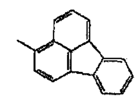 |
| 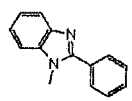 | 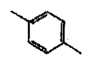 | 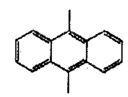 | 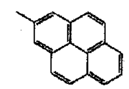 |
| 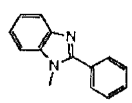 | 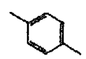 | 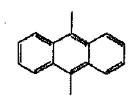 | 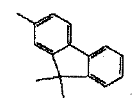 |
| 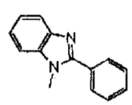 | 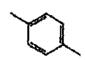 | 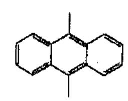 | 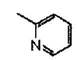 |

(continued)

| HAr -L - $Ar^1$ - $Ar^2$ | | | |
|---|---|---|---|
| HAr | L | $Ar^1$ | $Ar^2$ |
| 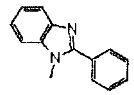 | 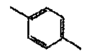 | 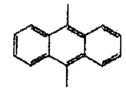 | 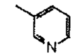 |
| 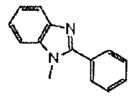 | 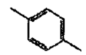 | 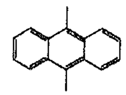 | 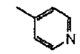 |
| 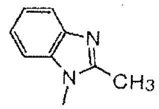 | 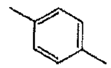 | 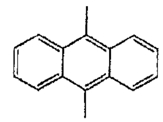 | 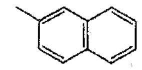 |
| 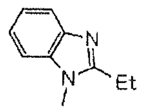 | 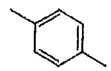 | 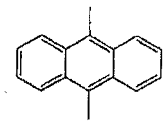 | 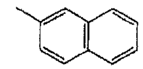 |
| 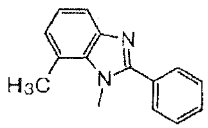 | 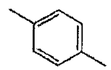 | 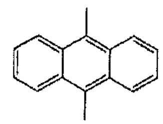 | 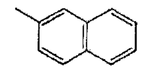 |
| 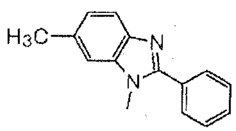 | 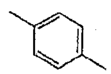 | 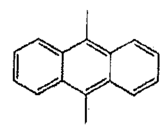 | 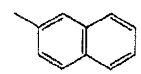 |

(continued)

HAr -L - $Ar^1$ - $Ar^2$

| HAr | L | $Ar^1$ | $Ar^2$ |
|---|---|---|---|
| 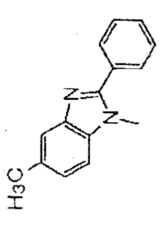 | 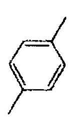 | 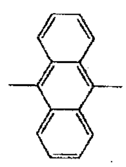 | 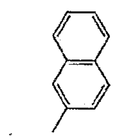 |
| 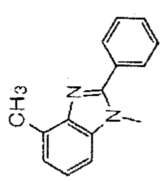 | 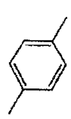 | 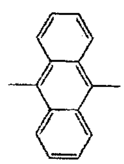 | 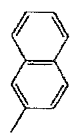 |
| 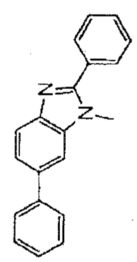 | 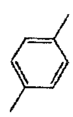 | 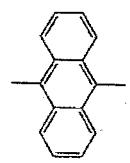 | 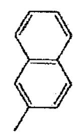 |
| 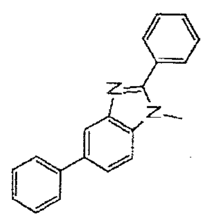 | 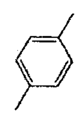 | 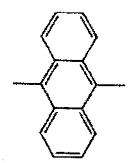 | 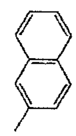 |

(continued)

HAr -L - $Ar^1$ - $Ar^2$

| HAr | L | $Ar^1$ | $Ar^2$ |
|---|---|---|---|
| 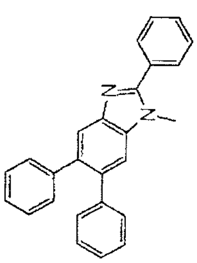 | 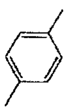 | 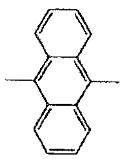 | 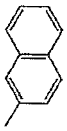 |
| 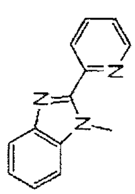 | 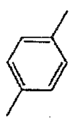 | 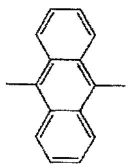 | 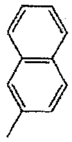 |
| 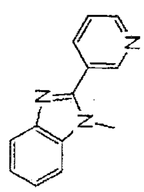 | 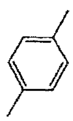 | 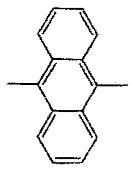 | 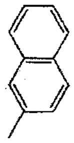 |
| 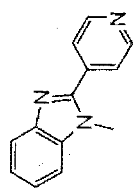 | 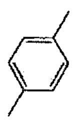 | 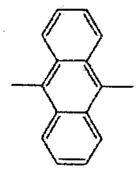 | 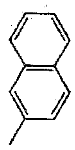 |

(continued)

| HAr -L - Ar$^1$ - Ar$^2$ | | | |
|---|---|---|---|
| HAr | L | Ar$^1$ | Ar$^2$ |
| 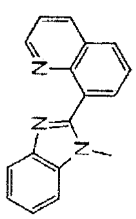 | 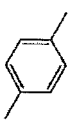 | 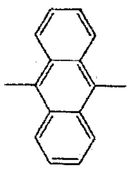 | 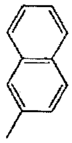 |
| 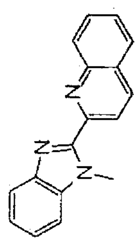 | 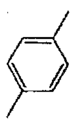 | 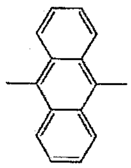 | 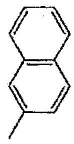 |
| 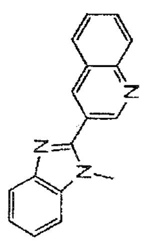 | 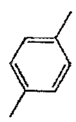 | 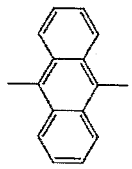 | 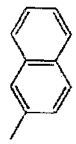 |
| 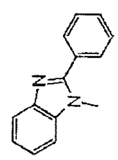 | 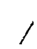 | 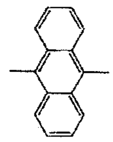 | 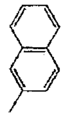 |
| 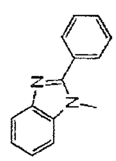 | 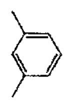 | 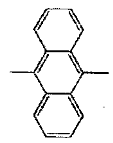 | 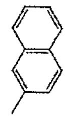 |

(continued)

HAr -L - $Ar^1$ - $Ar^2$

| HAr | L | $Ar^1$ | $Ar^2$ |
|---|---|---|---|
| 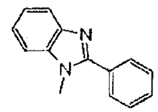 | 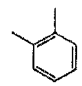 | 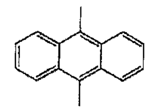 | 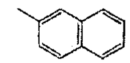 |
| 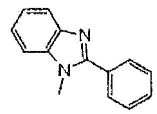 | 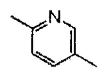 | 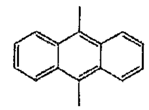 | 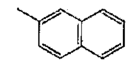 |
| 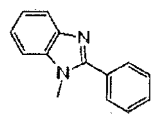 | 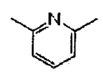 | 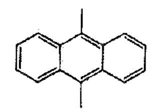 | 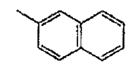 |
| 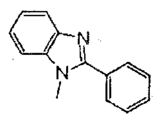 | 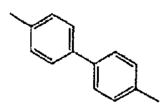 | 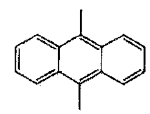 | 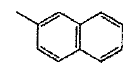 |
| 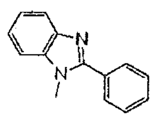 | 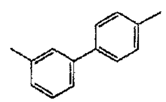 | 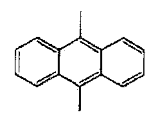 | 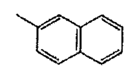 |
| 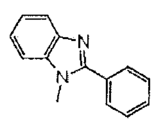 | 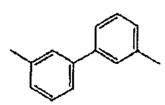 | 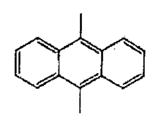 | 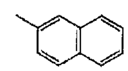 |

(continued)

HAr -L - $Ar^1$ - $Ar^2$

| HAr | L | $Ar^1$ | $Ar^2$ |
|---|---|---|---|
| 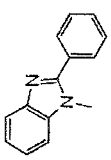 | 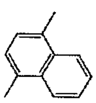 | 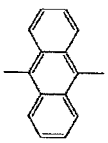 | 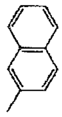 |
| 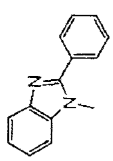 | 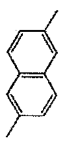 | 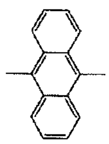 | 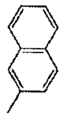 |
| 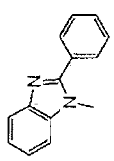 | 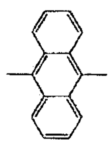 | 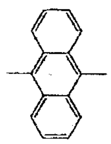 | 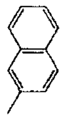 |
| 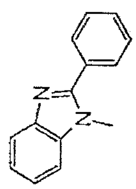 | 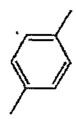 | 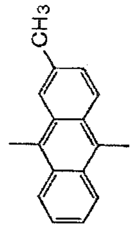 | 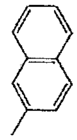 |
| 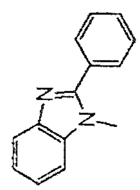 | 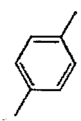 | 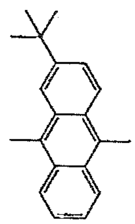 | 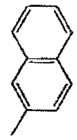 |

(continued)

| HAr | L | Ar$^1$ | Ar$^2$ |
|---|---|---|---|
| 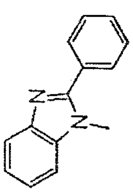 | 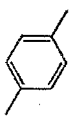 | 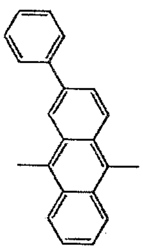 | 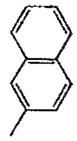 |
| 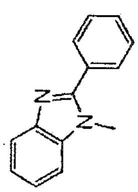 | 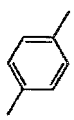 | 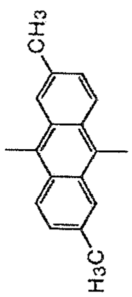 | 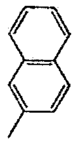 |
| 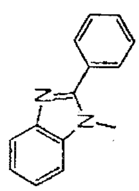 | 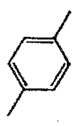 | 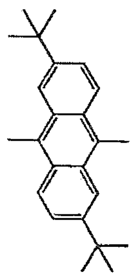 | 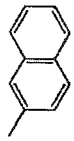 |
| 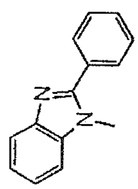 | 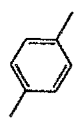 | 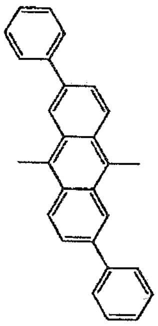 | 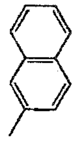 |
| 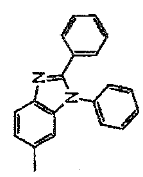 | 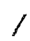 | 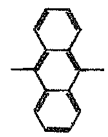 | 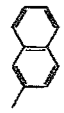 |

HAr -L - Ar$^1$ - Ar$^2$

(continued)

HAr -L - $Ar^1$ - $Ar^2$

| HAr | L | $Ar^1$ | $Ar^2$ |
|---|---|---|---|
| 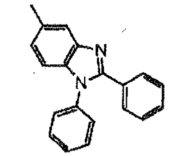 | — | 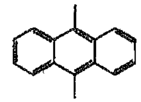 | 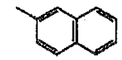 |
| 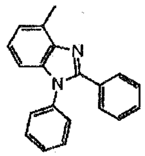 | — | 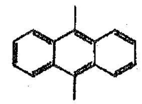 | 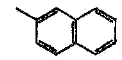 |
| 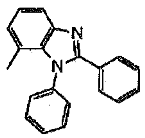 | — | 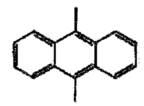 | 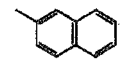 |
| 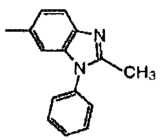 | — | 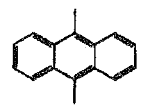 | 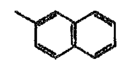 |
| 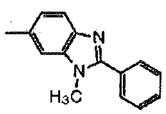 | — | 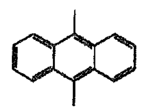 | 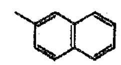 |

(continued)

HAr -L - $Ar^1$ - $Ar^2$

| HAr | L | $Ar^1$ | $Ar^2$ |
|---|---|---|---|
| 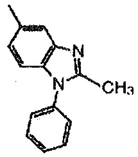 | 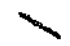 | 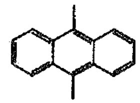 | 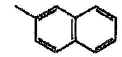 |
| 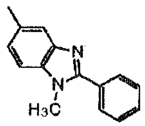 | 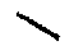 | 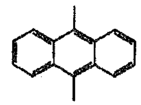 | 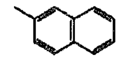 |
| 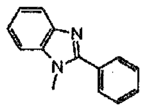 | 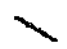 | 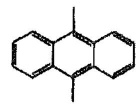 | 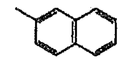 |
| 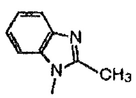 | 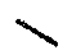 | 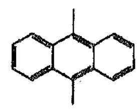 | 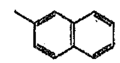 |
| 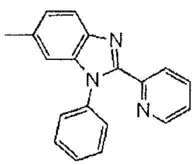 | 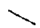 | 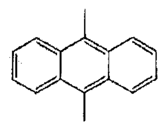 | 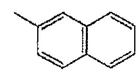 |

(continued)

HAr -L - Ar$^1$ - Ar$^2$

| HAr | L | Ar$^1$ | Ar$^2$ |
|---|---|---|---|
| 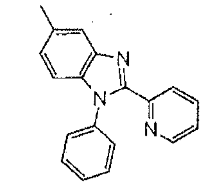 | 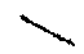 | 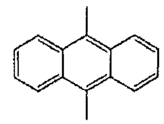 | 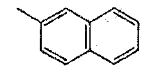 |
| 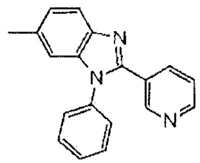 | 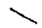 | 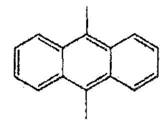 | 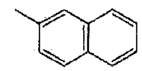 |
| 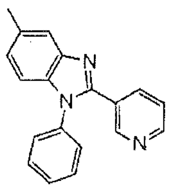 | 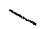 | 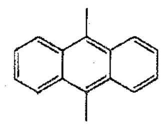 | 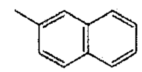 |
| 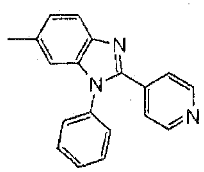 | 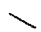 | 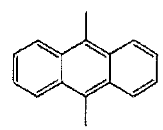 | 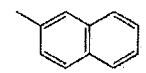 |

(continued)

HAr -L - $Ar^1$ - $Ar^2$

| HAr | L | $Ar^1$ | $Ar^2$ |
|---|---|---|---|
| 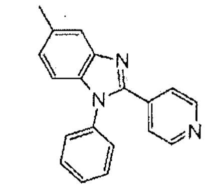 | | 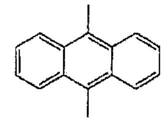 | 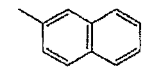 |
| 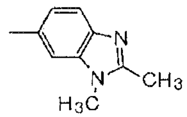 | | 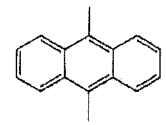 | 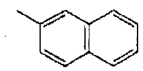 |
| 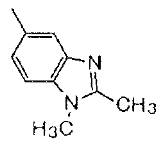 | | 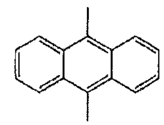 | 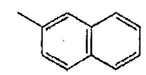 |
| 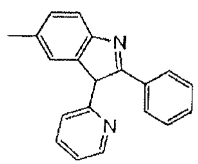 | | 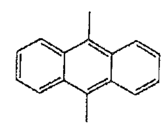 | 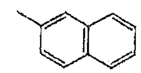 |

(continued)

HAr -L - $Ar^1$ - $Ar^2$

| HAr | L | $Ar^1$ | $Ar^2$ |
|---|---|---|---|
| 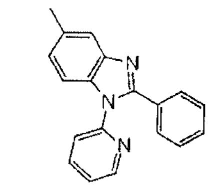 | 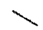 | 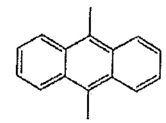 | 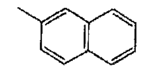 |
| 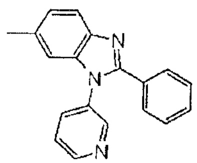 | 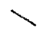 | 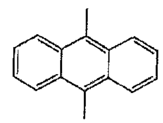 | 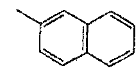 |
| 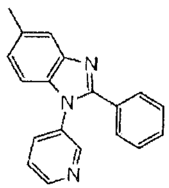 | 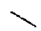 | 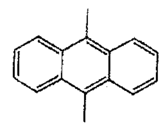 | 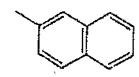 |
| 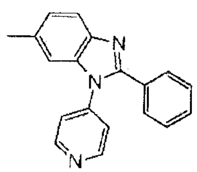 | 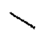 | 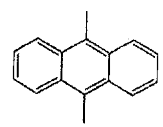 | 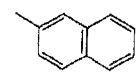 |

(continued)

HAr -L - $Ar^1$ - $Ar^2$

| HAr | L | $Ar^1$ | $Ar^2$ |
| --- | --- | --- | --- |
| 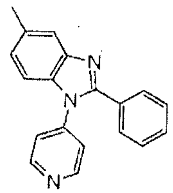 | 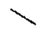 | 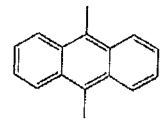 | 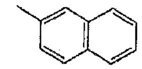 |
| 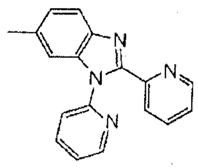 | 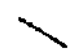 | 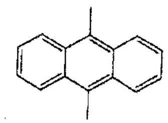 | 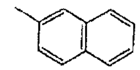 |
| 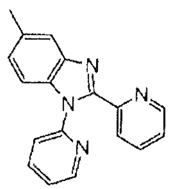 | 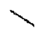 | 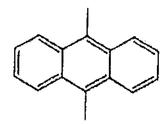 | 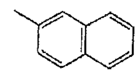 |

In the electron-transporting layer, the above-mentioned compound containing a nitrogen-containing heterocycle and the above-mentioned compound containing an anthracene skeleton may be used in combination.
The thickness of the electron-transporting layer is preferably 0.1 to 100 nm.

A preferred embodiment of the invention is a device containing a reducing dopant in an interfacial region between the cathode and the organic layers. The reducing dopant is defined as a substance which can reduce an electron-transporting compound. Accordingly, various substances which have given reducing property can be used. For example, at least one substance can be preferably used which is selected from the group consisting of alkali metals, alkaline earth metals, rare earth metals, alkali metal oxides, alkali metal halides, alkaline earth metal oxides, alkaline earth metal halides, rare earth metal oxides, rare earth metal halides, alkali metal organic complexes, alkaline earth metal organic complexes, and rare earth metal organic complexes.

More specific examples of the preferred reducing dopants include at least one alkali metal selected from the group consisting of Na (work function: 2.36 eV), K (work function: 2.28 eV), Rb (work function: 2.16 eV) and Cs (work function: 1.95 eV), and at least one alkaline earth metal selected from the group consisting of Ca (work function: 2.9 eV), Sr (work function: 2.0 to 2.5 eV), and Ba (work function: 2.52 eV). Metals having a work function of 2. 9 eV or less are particularly preferred. Among these, a more preferable reducing dopant is at least one alkali metal selected from the group consisting of K, Rb and Cs. Even more preferable is Rb or Cs. Most preferable is Cs. These alkali metals are particularly high in reducing ability. Thus, the addition of a relatively small amount thereof to an electron-injecting zone improves the luminance of the organic EL device and makes the life thereof long. As a reducing agent having a work function of 2.9 eV or less, combinations of two or more alkali metals are preferable, particularly combinations including Cs, such as Cs and Na, Cs and K, Cs and Rb, or Cs, Na and K are preferable. The combination containing Cs makes it possible to exhibit the reducing ability efficiently. The luminance of the organic EL device can be improved and the life thereof can be made long by the addition thereof to its electron-injecting zone.

In the invention, an electron-transporting layer formed of an insulator or a semiconductor may further be provided between the cathode and the organic layers. By forming the electron-transporting layer, a current leakage can be effectively prevented and electron-injecting properties can be improved. As the insulator, at least one metal compound selected from the group consisting of alkali metal calcogenides, alkaline earth metal calcogenides, halides of alkali metals and halides of alkaline earth metals can be preferably used. When the electron-transporting layer is formed of the alkali metal calcogenide or the like, the injection of electrons can be preferably further improved. Specifically, preferable alkali metal calcogenides include $Li_2O$, LiO, $Na_2S$, $Na_2Se$ and NaO and preferable alkaline earth metal calcogenides include CaO, BaO, SrO, BeO, BaS and CaSe. Preferable halides of alkali metals include LiF, NaF, KF, CsF, LiCl, KCl and NaCl. Preferable halides of alkaline earth metals include fluorides such as $CaF_2$, $BaF_2$, $SrF_2$, $MgF_2$ and $BeF_2$ and halides other than fluorides.

Semiconductors forming an electron-transporting layer include one or combinations of two or more of oxides, nitrides, and oxidized nitrides containing at least one element of Ba, Ca, Sr, Yb, Al, Ga, In, Li, Na, Cd, Mg, Si, Ta, Sb and Zn. An inorganic compound forming an electron-transporting layer is preferably a microcrystalline or amorphous insulating thin film. When the electron-transporting layer is formed of the insulating thin films, more uniformed thin film is formed, whereby pixel defects such as a dark spot are decreased. Examples of such an inorganic compound include the above-mentioned alkali metal calcogenides, alkaline earth metal calcogenides, halides of alkali metals, and halides of alkaline earth metals.

[Acceptor Layer]

The acceptor layer is a layer containing an acceptor. An acceptor is an easily-reducible organic compound.
The easiness of reduction of a compound can be measured by a reduction potential. In the invention, in terms of a reduction potential obtained by using a saturated calomel electrode (SCE) as a reference electrode, it is preferable to use a compound having a reduction potential of -0.3V or more, more preferably -0.8V or more. A compound having a reduction potential larger than the reduction potential of tetracyanoquinodimethane (TCNQ) (about 0V) is particularly preferable.

The acceptor is preferably an organic compound having an electron attracting substituent or an electron-deficient ring.
As examples of the electron attracting substituent, halogen, CN-, a carbonyl group, an aryl boron group, and the like can be given.
As examples of the electron-deficient ring, a compound selected from the group consisting of 2-pyridyl, 3-pyridyl, 4-pyridyl, 2-quinolyl, 3-quinolyl, 4-quinolyl, 2-imidazole, 4-imidazole, 3-pyrazole, 4-pyrazole, pyridazine, pyrimidine, pyrazine, cinnoline, phthalazine, quinazoline, quinoxaline, 3-(1,2,4-N)-triazolyl, 5-(1,2,4-N)-triazolyl, 5-tetrazolyl, 4-(1-O,3-N)-oxazole, 5-(1-O,3-N)-oxazole, 4-(1-S,3-N)-thiazole, 5-(1-S,3-N)-thiazole, 2-benzoxazole, 2-benzothiazole, 4-(1,2,3-N)-benzotriazole, and benzimidazole, and the like can be given. Note that the electron-deficient ring is not limited thereto.

Preferred examples of the acceptor include a quinoid derivative, an arylborane derivative, a thiopyrane dioxide

derivative and an imide derivative such as a naphthalimide derivative, and a hexaazatriphenylene derivative.

The following compounds are preferable as the quinoid derivative.

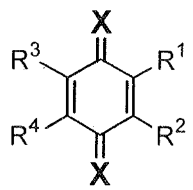
(1a)

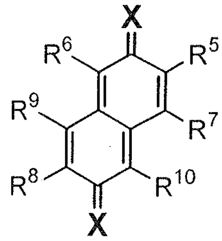
(1b)

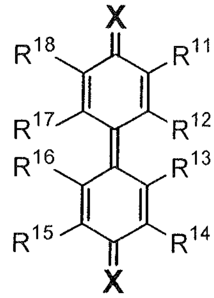
(1c)

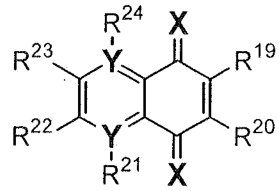
(1d)

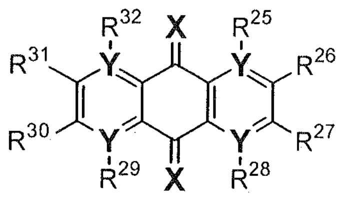
(1e)

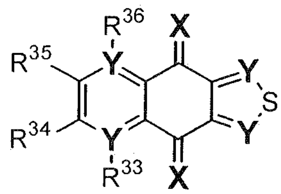
(1f)

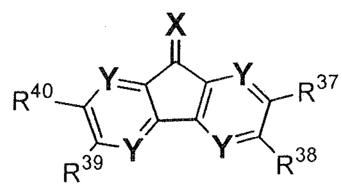
(1g)

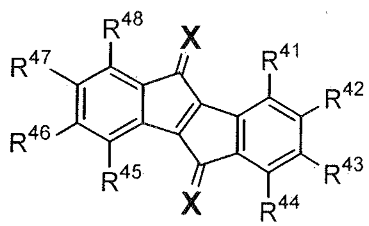
(1h)

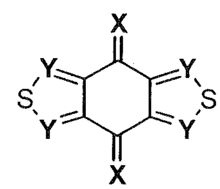
(1i)

wherein $R^1$ to $R^{48}$ are independently a hydrogen atom, a halogen atom, a fluoroalkyl group, a cyano group, an alkoxy group, an alkyl group, or an aryl group, excluding the case where all of $R^1$ to $R^{48}$ are hydrogen or fluorine in the same molecule; and X is an electron-attracting group, and has a structure represented by one of the following structures (j) to (p). The structures of the formulas (j), (k), and (l) are preferable.

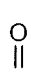
(j)

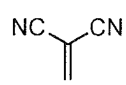
(k)

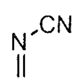
(l)

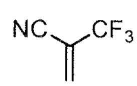
(m)

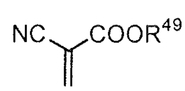
(n)

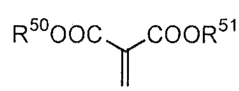
(o)

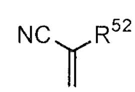
(p)

wherein $R^{49}$ to $R^{52}$ are independently hydrogen, a fluoroalkyl group, an alkyl group, an aryl group, or a heterocyclic ring; and $R^{50}$ and $R^{51}$ may form a ring.

Y is -N= or -CH=.

As specific examples of the quinoid derivative, the following compounds can be given.

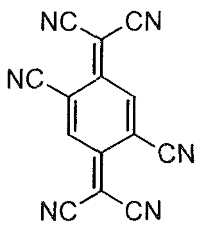

$(CN)_2$-TCNQ

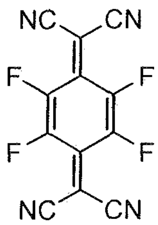

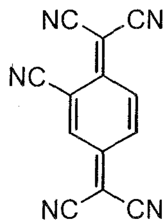

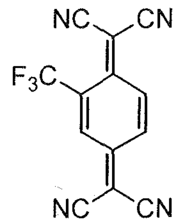

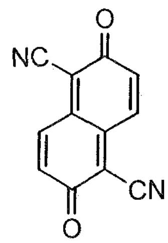

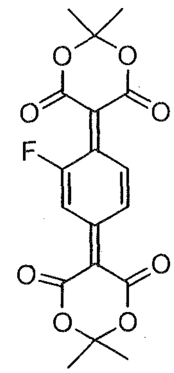

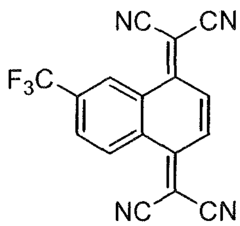

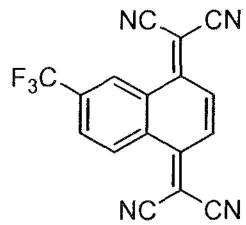

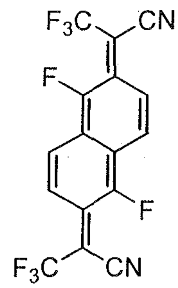

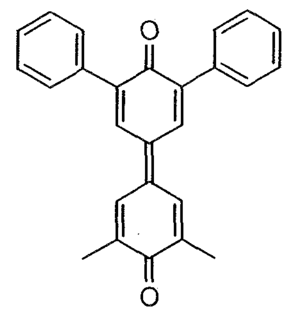

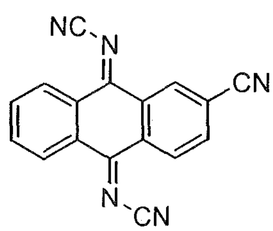

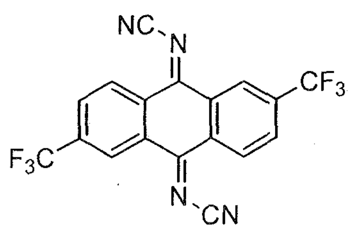

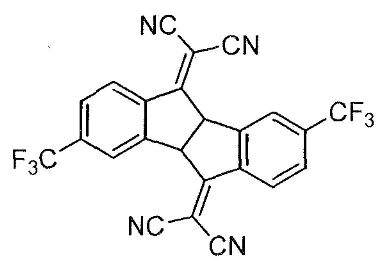

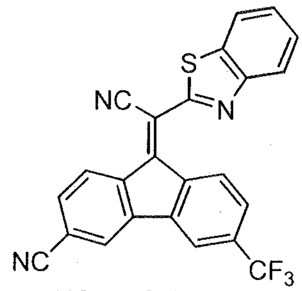
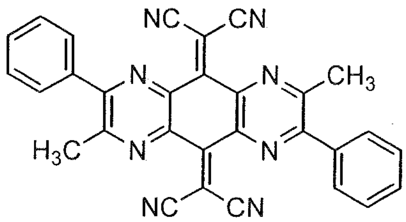
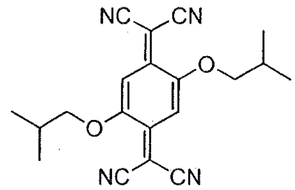
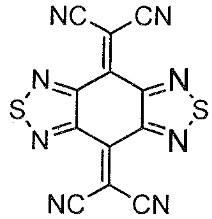

It is preferred that the acceptor be capable of being formed into a thin film. Specifically, it is preferred that an acceptor layer be formed by vapor deposition. The expression "capable of being formed into a thin film" means "capable of being formed into a smooth, thin film on a substrate by a common thin film-forming method such as vacuum vapor deposition and spin coating". Here, the "smooth" means a smaller degree of the roughness of the thin film. The surface roughness (Ra) is preferably 10 nm or less, more preferably 1.5 nm or less, still more preferably 1 nm or less. The surface roughness can be measured by means of an atomic force microscope (AFM).

As organic compounds capable of being formed into a thin film, amorphous organic compounds are preferable, with amorphous quinodimethane derivatives being still more preferable. An amorphous quinodimethane derivative having 5 or more CN-groups is further preferable. For example, $(CN)_2$-TCNQ as mentioned above can be given.

The content of an acceptor contained in the acceptor layer is preferably 1 to 100 mole%, more preferably 50 to 100 mole%, relative to the whole layer.

The acceptor layer may contain a hole-transporting and light-transmissive substance in addition to the acceptor. The substance is, however, not limited thereto.

The thickness of the acceptor layer is preferably 1 to 100 nm.

Compounds having the following structure are preferable as the arylborane derivative.

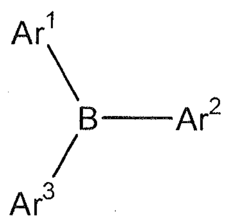

(2 a)

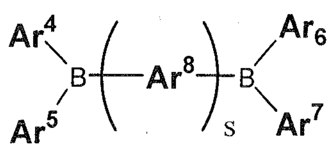

(2 b)

wherein $Ar^1$ to $Ar^7$ are independently an aryl group having an electron-attracting group (including a heterocycle); $Ar^8$ is an arylene group having an electron-attracting group; and S represents 1 or 2.

As specific examples of the arylborane derivative, the following compounds can be given.

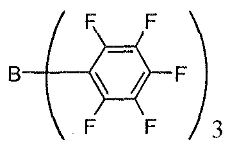

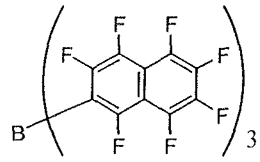

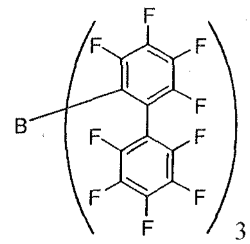

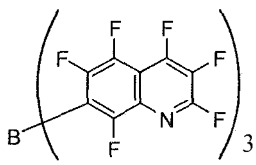

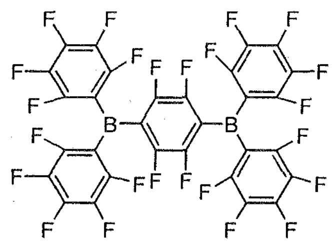

An arylborane compound having at least one fluorine atom as the substituent for the aryl group is particularly preferable. Examples of such a compound include tris-β-(pentafluoronaphthyl)borane(PNB).

Preferred examples of the imide derivative include naphthalene tetracarboxylic diimide compounds and pyromellitic diimide compounds.

Examples of the thiopyranedioxide derivative and the thioxanthene dioxide derivative include the compound (3a) and the compound (3b) which are given below, respectively.

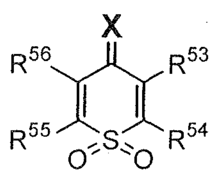

(3a)

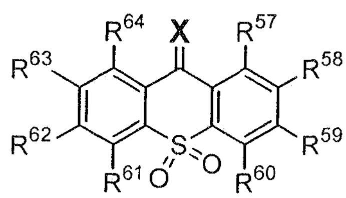

(3b)

In the formulas (3a) and (3b), $R^{53}$ to $R^{64}$ are independently hydrogen, halogen, a fluoroalkyl group, cyano group, alkyl group, or aryl group. Hydrogen and a cyano group are preferable.

In the formulas (3a) and (3b), X represents an electron-attracting group and is the same as that of X in the formulas (1a) to (1i). The structures of the formulas (j), (k), and (l) are preferable.

The halogen, fluoroalkyl group, alkyl group, and aryl group represented by $R^{53}$ to $R^{64}$ are the same as those of $R^1$ to $R^{48}$.

Specific examples of the thiopyrane dioxide derivatives represented by the formula (3a) and the thioxanthene dioxide derivatives represented by the formula (3b) are given below.

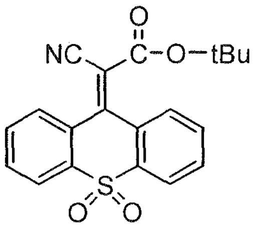

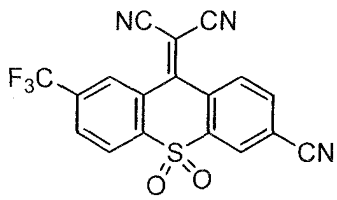

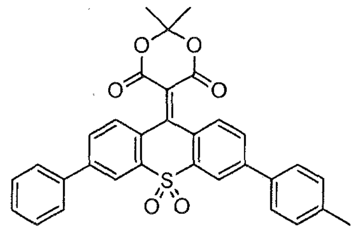

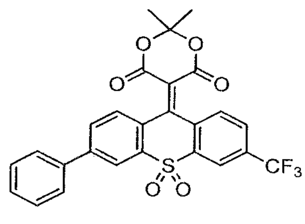

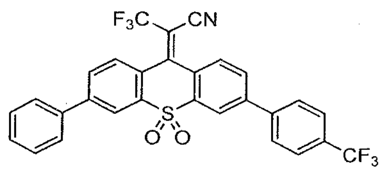

wherein tBu is a tert-butyl group.

In the above formulas (1a) to (1i) and (3a) to (3b), the electron-attracting group X may be a substituent (x) or a substituent (y) represented by the following formulas.

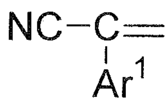
(x)

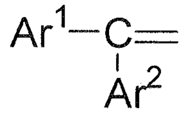
(y)

wherein $Ar^1$ and $Ar^2$ are independently a substituted or unsubstituted heterocycle, a substituted or unsubstituted aryloxycarbonyl or aldehyde. Preferably, $Ar^1$ and $Ar^2$ are pyridine, pyrazine and quinoxaline. $Ar^1$ and $Ar^2$ may be bonded to each other to form a 5- or 6-membered ring.

As the hexaazatriphenylene derivative, the structure given below is preferable. A compound having a cyano group is particularly preferable.

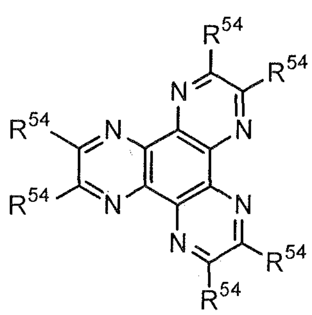

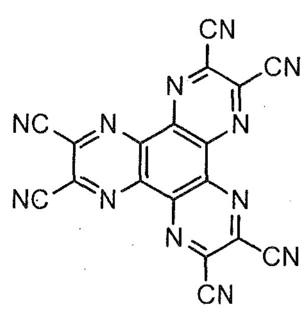

wherein $R^{54}$ are independently an alkyl group having 1 to 10 carbon atoms, an alkoxy group having 1 to 10 carbon atoms and an aryloxy group having 6 to 20 carbon atoms.

Although the acceptor layer may be provided between the anode or the cathode and the organic layers, it is preferred that the acceptor layer be provided between the anode and the organic layers.

[Donor layer]

The donor layer is a layer which contains as a donor at least one selected from the group consisting of a donor metal, a donor metal compound and a donor metal complex.

The donor metal is a metal having a work function of 3.8 eV or less. The donor metal is preferably an alkaline metal, an alkaline earth metal and a rare earth metal. More preferably, the donor metal is Cs, Li, Na, Sr, K, Mg, Ca, Ba, Yb, Eu and Ce.

The donor metal compound is a compound which contains the above-mentioned donor metal, preferably a compound which contains an alkali metal, an alkaline earth metal or a rare earth metal, and more preferably a compound containing a halide, an oxide, a carbonate and a borate of these metals. For example, the donor metal compound is a compound shown by $MO_x$ (M is a donor metal, x is 0.5 to 1.5), $MF_x$ (x is 1 to 3) and $M(CO_3)_x$ (x is 0.5 to 1.5).

The donor metal complex is a complex of the above-mentioned donor metal, preferably an organic metal complex of an alkaline metal, an alkaline earth metal or a rare earth metal. Preferably, an organic metal complex shown by the following formula (I):

$$M(Q)_n \qquad (1)$$

wherein M is a donor metal, Q is a ligand, preferably an carboxylic acid derivative, a diketone derivative and a quinoline derivative, and n is an integer of 1 to 4.

Specific examples of the donor metal complex include a tungsten paddlewheel disclosed in JP-A-2005-72012. In addition, a phthalocyanine compound having an alkali metal or an alkaline earth metal as a central metal as disclosed in JP-A-11-345687 may be used as a donor metal complex.

The above-mentioned donors may be used singly or in combination of two or more.

The content of a donor contained in the donor layer is 1 to 100 mole%, more preferably 50 to 100 mole%.

In addition to the above-mentioned donor, the donor layer may contain one or a plurality of substances insofar as the substance is light-transmissive. Specific examples of such a substance include, though not limited thereto, organic substances such as an amine compound, a condensed ring compound, a nitrogen-containing heterocyclic compound and a metal complex and inorganic substances such as metal oxides, metal nitrides, metal fluorides and carbonates.

The thickness of the donor layer is preferably 1 to 100 nm.

The donor layer may be provided between the anode or the cathode and the organic layers. It is preferred that the donor layer be provided between the cathode and the organic layers.

EXAMPLES

The compounds used in the examples and the comparative examples are illustrated below.

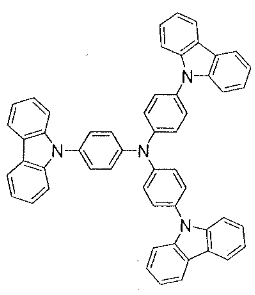
TCTA

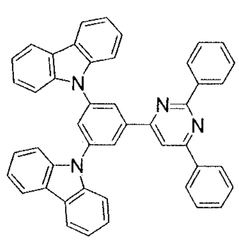
Host A

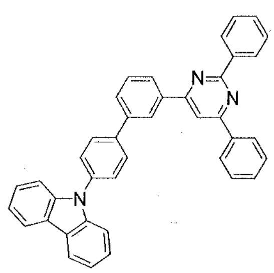
Host B

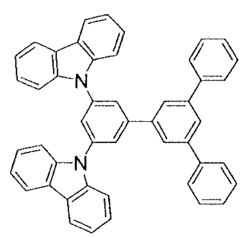
Host C

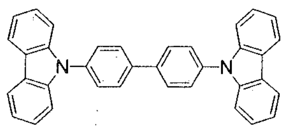

CBP

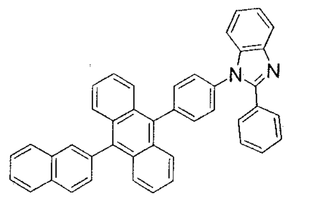

Electron-transporting material A

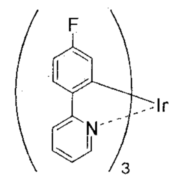

Complex A

The carrier (hole and electron) mobility, inonization potential, singlet energy gap or triplet energy gap of these materials were measured by the following method.

1. Measurement of mobility

A glass substrate of 25 mm by 75 mm by 1.1 mm thick with an ITO transparent electrode (GEOMATEC CO., LTD.) was subj ected to ultrasonic cleaning with isopropyl alcohol for 5 minutes, and cleaned with ultraviolet rays and ozone for 30 minutes. The thus cleaned glass substrate was mounted on a substrate holder in a vacuum vapor deposition apparatus. First, a measurement material was formed on the ITO transparent electrode into a film of 3 to 5 $\mu$m by resistance heating deposition. Subsequently, a metal Al was deposited in a thickness of 10 nm, whereby a transparent electrode was formed.
The carrier (hole and electron) mobility in an electric field intensity of 0.4 to 0.5 MV/cm was measured by means of a time-of-flight measurement apparatus (TOF-401, manufactured by Optel Co., Ltd.). Light with a wavelength of 337 nm emitted from a nitrogen laser was used as an exited light. A photocurrent intensity (I)-time (t) curve was plotted by double logarithms, and the resulting critical point was taken as tr. The mobility can be obtained by the expression $\mu = L^2/(tr \times V)$, wherein L is the sample thickness and V is the applied voltage.
The value obtained by this method is shown in Table 1.

2. Measurement of ionization potential

The materials for measurement were deposited on a glass substrate in a thickness of 1000Å, and stored under the nitrogen atmosphere until immediately before the measurement. Using these films, the value of energy of photoelectrons jumping out was measured by means of an UV photoelectron spectroscopy equipment (AC-3, manufactured by Riken Keiki Co., Ltd). The value of inonization potential (Ip) was obtained from an intersecting point in the graph of a rising linear region and a baseline. The obtained values are shown in Table 1.

3. Singlet energy gap ($Eg^s$) measurement

A toluene solution of each material was irradiated with wavelength-resolved light. The singlet energy gap was obtained by conversion from the longest wavelength of the absorption spectrum. As the apparatus for measurement, a spectrophotometer (U-3400 (Product Name), manufactured by Hitachi Corporation) was used. Specifically, the tangent line was drawn against the falling of the longest wavelength of the absorption spectra, and then the the wavelength value $\lambda_{edge}$ (unit: nm) at the intersection of the tangent line with the axis of abscissa was obtained. An energy gap was calculated by converting the wavelength value to an energy value using the conversion equation Eg(s) (eV) = $1239.85/\lambda_{edge}$. The obtained value is shown in Table 2.

4. Triplet energy gap ($Eg^T$) measurement

The triplet energy gap ($Eg^T$(Dopant)) was obtaned by the following method. An organic material was measured by a known method (the method written in "The World of Photochemistry" edited by the Chemistry Society of Japan, 1993, around page 50). Specifically, an organic meterial was dissolved in a solvent (a sample 10 $\mu$mol/L EPA (diethyl ether:isopentane:ethanol = 5:5:2 at a volume ratio), each solvent was of the spectroscopic grade ) to obtain a sample for a photophospherent measurement. The sample was put in a quartz cell and cooled to 77K. Exciting light was irradiated to measure emitted phosphorescence for wavelength. Then tangent line was drawn to the rise on the short-wavelength side of the obtained phosphorescent spectrum. The wavelength value was converted to energy, which was a triplet

energy gap value ($Eg^T$). The main body of a fluorescence spectrophotometer F-4500 manufactured by Hitachi, Ltd. and optional fittings for low-temprature measurement were used for the measurement. The measurement apparatus is not limited thereto, and measurement may be performed by using a cooling apparatus and a container for low-temperture measurement, an exciting light source and a light-receiving apparatus in combination.
In the Examples, the wavelength was converted by the following formula:

$$\text{Conversion equation: } Eg^T(eV) = 1239.85/\lambda_{edge}$$

The "$\lambda_{edge}$" means the wavelength value at the intersection of the tangent line with the axis of abscissa obtained by a method in which the tangent line was drawn against the rise of the shortest wavelength of the phosphorescent spectra when a phospherescent spectrum was expressed taking the intensity of phosphorescence and the wavelength at the axis of ordinates and the axis of abscissa, respectively. Unit: nm
The values obtained are shown in Table 2.
Table 1

| Material | Ionization potential energy: thin film (eV) | Mobility ($cm^2/Vs$) | | Electron mobility ÷ hole mobility |
|---|---|---|---|---|
| | | Hole mobility | Electron mobility | |
| Host material A | 6.1 | $2.99\times10^{-5}$ | $2.90\times10^{-5}$ | $9.70\times10^{-1}$ |
| Host material B | 6.0 | $1.71\times10^{-5}$ | $1.56\times10^{-5}$ | $9.12\times10^{-5}$ |
| Host material C | 6.0 | $1.23\times10^{-4}$ | $2.75\times10^{-5}$ | $2.24\times10^{-1}$ |
| Host material CBP | 6.1 | $1.15\times10^{-3}$ | $1.90\times10^{-4}$ | $1.65\times10^{-1}$ |
| Electron-transporting material A | 6.0 | $3.38\times10^{-5}$ | $3.70\times10^{-4}$ | $1.09\times10^{1}$ |

Table 2

| Material | $Eg^S$ (eV) | $Eg^T$(eV) |
|---|---|---|
| Host material A | 3.55 | 2.90 |
| Host material B | 3.53 | 2.88 |
| Host material C | 3.57 | 2.89 |
| Host material CBP | 3.51 | 2.81 |
| Electron-transporting material A | 3.00 | 1.82 |

Example 1

(Fabrication of an Organic EL device)

A glass substrate of 25 mm by 75 mm by 1.1 mm thick with an ITO transparent electrode (GEOMATEC CO., LTD.) was subjected to ultrasonic cleaning with isopropyl alcohol for 5 minutes, and cleaned with ultraviolet rays and ozone for 30 minutes. The thus cleaned substrate with transparent electrode lines was mounted on a substrate holder in a vacuum deposition device. First, a TCTA film was formed in a thickness of 95 nm so as to cover the surface of the transparent electrode on which the transparent electrode lines were formed. This TCTA film functioned as a hole-transporting layer. Subsequent to the formation of the hole-transporting layer, the host A and the complex A were co-deposited in a film thickness of 30 nm by resistance heating. The concentration of the complex A was 7.5 wt%. This host A: complex A film functioned as an emitting layer. Subsequent to the formation of the emitting layer, the electron-transporting material A was formed into a film with a thickness of 25 nm. The electron-transporting material A functioned

as an electron-transporting layer. Thereafter, LiF was formed into a film with a thickness of 1 nm at a film-forming speed of 1Å/min as an electron-injecting electrode (cathode). Metal Al was deposited on this LiF layer to form a metal Al cathode with a thickness of 150 nm, whereby an organic EL device was obtained.

(Evaluation of emission performance of the organic EL device)

The thus obtained organic EL device was allowed to emit light by DC driving (current density J=1 $mA/cm^2$) to measure emission wavelength (λ) and luminance (L), whereby luminous efficiency (L/J) was obtained. The voltage (V), the current efficiency (cd/A) and the external quantum efficiency (%) were also measured. The time was obtained at an initial luminance of 1500 $cd/m^3$. The results obtained are shown in Table 3.

Example 2

An organic EL device was fabricated and evaluated in the same manner as in Example 1, except that the material B was used as the host material. The results are shown in Table 3.

Comparative Example 1

An organic EL device was fabricated and evaluated in the same manner as in Example 1, except that the material C was used as the host material. The results are shown in Table 3.

Comparative Example 2

An organic EL device was fabricated and evaluated in the same manner as in Example 1, except that the material CBP was used as the host material. The results are shown in Table 3.
Table 3

| | Material | Voltage (V) | Current efficiency (cd/A) | Luminous efficiency (lm/W) | External quantum efficiency (%) | Life (h) |
|---|---|---|---|---|---|---|
| Example 1 | Host material A | 4.4 | 48 | 34 | 18 | 340 |
| Example 2 | Host material B | 4.5 | 42 | 30 | 17 | 282 |
| Com. Ex. 1 | Host material C | 4.9 | 25 | 16 | 9.9 | 125 |
| Com. Ex. 2 | CBP | 5.0 | 19 | 13 | 7.5 | 88 |

In Comparative Examples 1 and 2, emission (peak: 430 nm) from the electron-transporting material B was observed. The organic EL devices fabricated in Examples were driven at a lower voltage and had a higher efficiency and a longer life than the organic EL devices fabricated in Comparative Examples.

INDUSTRIAL APPLICABILITY

The organic EL device of the invention can be applied to fields including various display elements, displays, backlights, illumination light sources, markings, signboards and the interior.
The contents of all the documents in this specification are incorporated herein by reference.

**Claims**

**1.** An organic electroluminescent device, comprising:

a cathode;
an anode; and

organic layers comprising at least an emitting layer and an electron-transporting layer between the cathode and the anode,
the electron-transporting material with the slowest electron mobility constituting the electron-transporting layer having an electron mobility of $2.0 \times 10^{-5}$ $cm^2/Vs$ or more in an electric field intensity of 0.4 to 0.5 MV/cm,
the electron mobility/hole mobility (ΔEM) of a host material constituting the emitting layer, and the electron mobility/hole mobility (ΔET) of the electron-transporting material with the slowest electron mobility constituting the electron-transporting layer satisfying the following relationship:

$$\Delta ET > 1$$

$$0.3 \leq \Delta EM \leq 10$$

$$\Delta ET > \Delta EM.$$

**2.** The organic electroluminescent device according to claim 1, wherein ΔET ≥ 3.

**3.** The organic electroluminescent device according to claim 1 or 2, wherein the ionization potential of the electron-transporting material is equal to or less than the ionization potential of the host material.

**4.** The organic electroluminescent device according to any one of claims 1 to 3, wherein the singlet energy gap or the triplet energy gap of the electron-transporting material is less than the singlet energy gap or the triplet energy gap of the host material.

**5.** The organic electroluminescent device according to any one of claims 1 to 4, wherein the emitting layer has at least one dopant material and at least one host material.

**6.** The organic electroluminescent device according to claim 5, wherein the dopant material is a phosphorescent material.

**7.** The organic electroluminescent device according to claim 6, wherein the phosphorescent material is an orthometalated metal complex.

**8.** The organic electroluminescent device according to any one of claims 5 to 7, wherein the dopant material has an emission peak of 500 nm or less.

**9.** An organic electroluminescent device according to any one of claims 1 to 8, wherein at least one electron-transporting material constituting the electron-transporting layer has a triplet energy gap of 2.1 eV or less.

**10.** The organic electroluminescent device according to any one of claims 1 to 9, wherein the electron-transporting layer comprises a compound having an anthracene skeleton.

**11.** The organic electroluminescent device according to claim 10, wherein the compound having an anthracene skeleton is shown by the following formula:

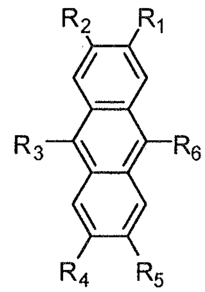

wherein $R_1$ to $R_6$ are independently a hydrogen atom, a substituted or unsubstituted alkyl group having 1 to 40 carbon atoms, a substituted or unsubstituted perfluoroalkyl group having 1 to 40 carbon atoms, a substituted or unsubstituted alkoxy group having 1 to 40 carbon atoms, a substituted or unsubstituted aralkyl group having 1 to 40 carbon atoms, a substituted or unsubstituted arylalkoxy group having 1 to 40 carbon atoms, a substituted or unsubstituted aryl group having 6 to 80 carbon atoms, a substituted or unsubstituted heterocyclic group having 3 to 80 carbon atoms, a substituted or unsubstituted alkylsilyl group having 1 to 40 carbon atoms, a substituted or unsubstituted arylsilyl group having 6 to 80 carbon atoms, or a cyano group, and adjacent substituents may be bonded to each other to form a ring.

**12.** The organic electroluminescent device according to any one of claims 1 to 11, wherein the electron-transporting layer comprises a condensed aromatic ring derivative containing an electron-deficient nitrogen-containing five-membered ring or a condensed aromatic ring derivative containing a nitrogen-containing six-membered ring.

**13.** The organic electroluminescent device according to claim 12, wherein the nitrogen-containing five-membered ring is an imidazole ring, a triazole ring, a tetrazole ring, an oxadiazole ring, a thiadiazole ring, an oxatriazole ring, or a thiatriazole ring.

**14.** The organic electroluminescent device according to claim 12, wherein the nitrogen-containing six-membered ring is a quinoxaline ring, a quinoline ring, a quinazoline ring, a pyridine ring, a pyrazine ring, or a pyrimidine ring.

**15.** The organic electroluminescent device according to any one of claims 1 to 14, wherein a reductive dopant is added in the interfacial region of the organic layers and the cathode.

**16.** The organic electroluminescent device according to any one of claims 1 to 15, wherein the emitting layer has a film thickness of 20 nm or more.

**17.** The organic electroluminescent device according to any one of claims 1 to 16, further comprising a donor layer or an accepter layer between at least one electrode of the cathode and the anode, and the organic layers.

FIG. 1

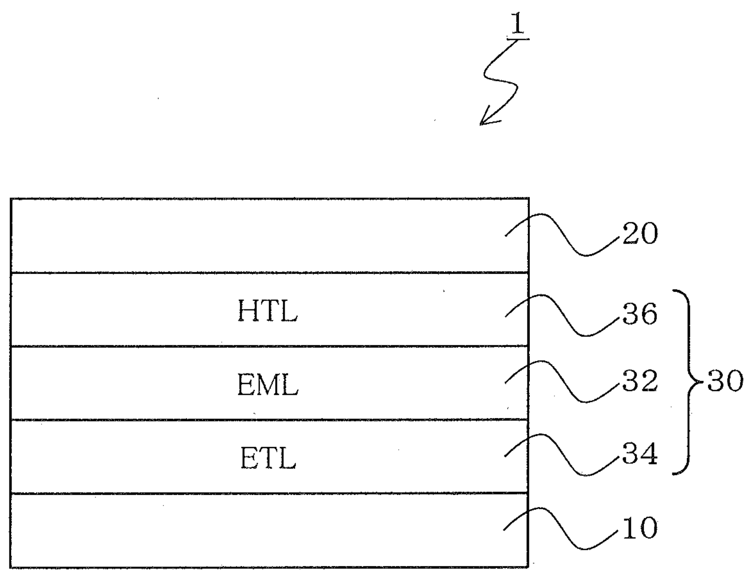

FIG. 2A

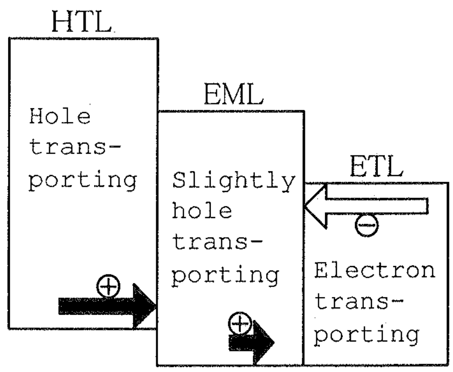


FIG. 2B

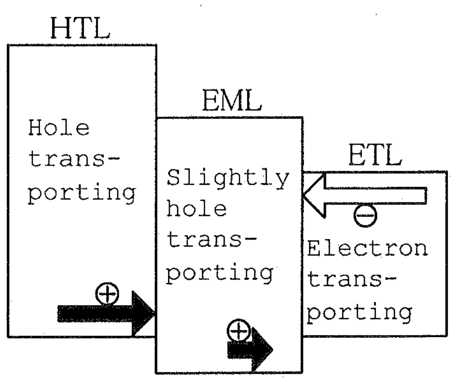


FIG. 3

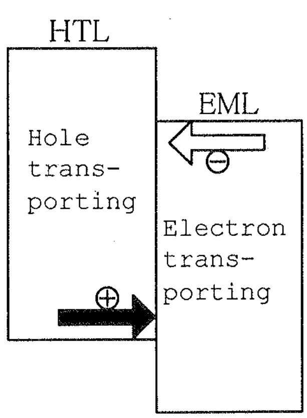

FIG. 4

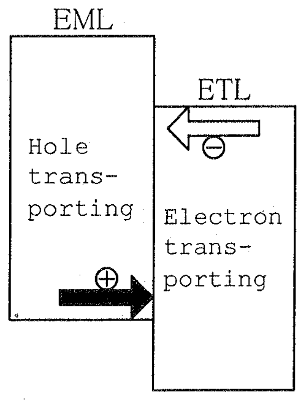


FIG. 5

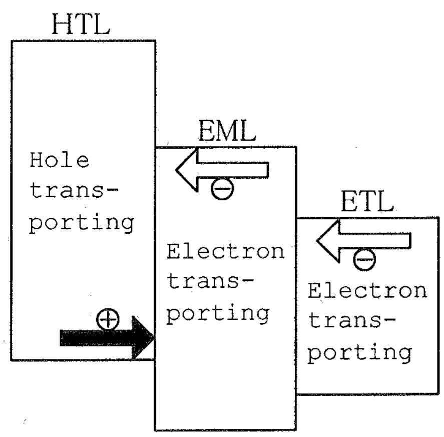


FIG. 6

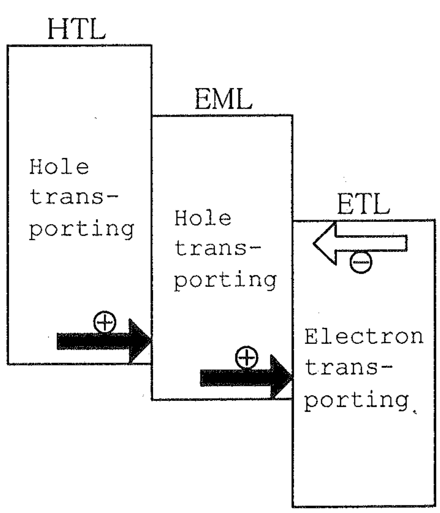

**INTERNATIONAL SEARCH REPORT**

International application No.
PCT/JP2007/064631

A. CLASSIFICATION OF SUBJECT MATTER
*H01L51/50*(2006.01)i, *C09K11/06*(2006.01)i

According to International Patent Classification (IPC) or to both national classification and IPC

B. FIELDS SEARCHED

Minimum documentation searched (classification system followed by classification symbols)
H01L51/50, C09K11/06

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | WO 2004/034751 A1 (Idemitsu Kosan Co., Ltd.), 22 April, 2004 (22.04.04), Claims 1 to 15; page 15, lines 1 to 9; page 51, lines 15 to 21; page 62, example 1; page 65, example 2 & EP 1551206 A1 | 1-17 |
| Y | WO 2004/080975 A1 (Idemitsu Kosan Co., Ltd.), 23 September, 2004 (23.09.04), Full text; table 1 & US 2006/0147747 A1 | 1-17 |
| Y | WO 2006/070817 A1 (Nagoya Industrial Science Research Institute), 06 July, 2006 (06.07.06), Par. No. [0003] (Family: none) | 1 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 16 October, 2007 (16.10.07) | 30 October, 2007 (30.10.07) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.
PCT/JP2007/064631

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2006-66890 A (Sanyo Electric Co., Ltd.), 09 March, 2006 (09.03.06), Par. Nos. [0005], [0006] & US 2006/0029828 A1 | 1 |
| Y | JP 2006-73581 A (Toray Industries, Inc.), 16 March, 2006 (16.03.06), Par. No. [0062] (Family: none) | 1 |
| Y | JP 2000-164359 A (Idemitsu Kosan Co., Ltd.), 16 June, 2000 (16.06.00), Par. No. [0033] (Family: none) | 1 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 3759925 B
- JP H1079297 A
- JP H10233284 A
- JP 2006049570 A
- US 6097147 A
- WO 2004077886 A
- JP 2002313583 A
- US 3112197 A
- US 3189447 A
- JP 3716096 B
- US 3615402 A
- US 3820989 A
- US 3542544 A
- JP 45555 B
- JP 51010983 B
- JP 51093224 A
- JP 55017105 A
- JP 56004148 A
- JP 55108667 A
- JP 55156953 A
- JP 56036656 A
- US 3180729 A
- US 4278746 A
- JP 55088064 A
- JP 55088065 A
- JP 49105537 A
- JP 55051086 A
- JP 56080051 A
- JP 56088141 A
- JP 57045545 A
- JP 54112637 A
- JP 55074546 A
- US 3615404 A
- JP 51010105 B
- JP 46003712 B
- JP 47025336 B
- JP 54119925 B
- US 3567450 A
- US 3240597 A
- US 3658520 A
- US 4232103 A
- US 4175961 A
- US 4012376 A
- JP 49035702 B
- JP 3927577 B
- JP 55144250 A
- JP 56119132 A
- JP 56022437 A
- DE 1110518
- US 3526501 A
- US 3257203 A
- JP 56046234 A
- JP 54110837 A
- US 3717462 A
- JP 54059143 A
- JP 55052063 A
- JP 55052064 A
- JP 55046760 A
- JP 57011350 A
- JP 57148749 A
- JP 2311591 A
- JP 61210363 A
- JP 61228451 A
- JP 61014642 A
- JP 61072255 A
- JP 62047646 A
- JP 62036674 A
- JP 62010652 A
- JP 62030255 A
- JP 60093455 A
- JP 60094462 A
- JP 60174749 A
- JP 60175052 A
- US 4950950 A
- JP 2204996 A
- JP 2282263 A
- JP 632956965 A
- US 4127412 A
- JP 53027033 A
- JP 54058445 A
- JP 54149634 A
- JP 54064299 A
- JP 55079450 A
- JP 61295558 A
- JP 61098353 A
- JP 63295695 A
- US 5061569 A
- JP 4308688 A
- JP 2004002297 A
- JP 9087616 A
- JP 9194487 A
- WO 0040586 A
- JP H10088121 A
- JP 2005072012 A
- JP 11345687 A

**Non-patent literature cited in the description**

- *Appl. Phys. Lett.,* 1999, vol. 75, 4
- *Proc. SPIE,* 2000, vol. 4105, 175-182